(19) **Europäisches Patentamt / European Patent Office / Office européen des brevets**

(11) **EP 1 597 599 B1**

(12) **EUROPÄISCHE PATENTSCHRIFT**

(45) Veröffentlichungstag und Bekanntmachung des Hinweises auf die Patenterteilung:
**20.06.2007 Patentblatt 2007/25**

(51) Int Cl.:
***G01R 15/24*** (2006.01)

(21) Anmeldenummer: **03714519.0**

(86) Internationale Anmeldenummer:
**PCT/CH2003/000109**

(22) Anmeldetag: **14.02.2003**

(87) Internationale Veröffentlichungsnummer:
**WO 2003/042708 (22.05.2003 Gazette 2003/21)**

(54) **FASEROPTISCHER STROMSENSOR MIT MEHREREN SENSORKÖPFEN**

OPTIC FIBER CURRENT SENSOR, COMPRISING SEVERAL SENSING HEADS

DETECTEUR DE COURANT A FIBRES OPTIQUES, COMPORTANT PLUSIEURS TETES DE DETECTION

(84) Benannte Vertragsstaaten:
**AT BE BG CH CY CZ DE DK EE ES FI FR GB GR HU IE IT LI LU MC NL PT SE SI SK TR**

(43) Veröffentlichungstag der Anmeldung:
**23.11.2005 Patentblatt 2005/47**

(73) Patentinhaber: **ABB RESEARCH LTD.**
**8050 Zürich (CH)**

(72) Erfinder:
• **BOHNERT, Klaus**
 **CH-5452 Oberrohrdorf (CH)**

• **GABUS, Philippe**
 **CH-5415 Nussbaumen (CH)**
• **BRÄNDLE, Hubert**
 **CH-8102 Oberengstringen (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(56) Entgegenhaltungen:
**EP-A- 1 154 278      EP-A- 1 245 961**
**US-A- 4 814 930**

EP 1 597 599 B1

Printed by Jouve, 75001 PARIS (FR)

**Beschreibung**

Technisches Gebiet

Die Erfindung bezieht sich auf das Gebiet der faseroptischen Sensorik. Sie bezieht sich auf einen faseroptischen Sensor zur Strom- oder Magnetfeldmessung gemäss dem Oberbegriff des Patentanspruches 1 und auf ein Verfahren zur Messung eines elektrischen Stromes oder Magnetfeldes gemäss dem Oberbegriff des Patentanspruches 12.

Stand der Technik

Ein derartiger Stromsensor ist beispielsweise aus EP 1 154 278 A2 bekannt. Dieser Sensor weist eine Lichtquelle, einen Detektor, einen Signalprozessor sowie einen Modulatorkreis und zwei Sensorköpfe auf. Licht wird von der Lichtquelle in den Modulatorkreis gekoppelt und breitet sich von dort in die zwei Sensorköpfe aus. Ein solcher Sensorkopf beinhaltet eine magnetooptisch aktive Sensorfaser, die spulenförmig um einen elektrischen Leiter angeordnet ist, in dem der zu messende elektrische Strom fliesst. Dadurch wird durch den Faraday-Effekt eine differentielle Phasenverschiebung zwischen zwei sich in einem derartigen Sensorkopf ausbreitenden zueinander orthogonal polarisierten Lichtwellen erzeugt.

Die Sensorköpfe weisen je ein verspiegeltes Ende auf, so dass sie, zusammen mit dem restlichen optischen Aufbau, je ein Reflexions-Interferometer bilden. Nach der Reflexion an den verspiegelten Enden wird das Licht zurück durch den Modulatorkreis geführt und in den Detektor gekoppelt. Der Signalprozessor wertet die Signale des Detektors aus. Der Modulatorkreis weist ein lichtquellen- und detektorseitiges Ende und ein sensorkopfseitiges Ende auf. Er dient der nicht-reziproken Modulation einer differentiellen Phase zweier sich gegenläufig ausbreitender, zueinander parallel polarisierter Lichtwellen. Dazu beinhaltet der Modulatorkreis einen mit seiner Resonanzfrequenz betriebenen piezoelektrischen Phasenmodulator, welcher von dem Signalprozessor gesteuert wird.

Die mittels des Modulatorkreises erzielte nicht-reziproke differentielle Phasenmodulation dient der Erzielung einer grösseren Auflösung bei der Detektion der durch den Faraday-Effekt induzierten differentiellen Phasenverschiebung. Der effektive Arbeitspunkt des Interferometers wird in einen linearen Bereich der kosinusförmigen Interferenzfunktion verschoben.

Um die von den zwei verschiedenen Sensorköpfen stammenden Signale in dem Signalprozessor unterscheiden zu können, wird ein Zeit-Multiplexing-Verfahren verwendet. Die Lichtquelle wird gepulst betrieben, und die Länge der zwei Reflexions-Interferometer wird verschieden gross gewählt. Dadurch entstehen verschieden lange Laufzeiten für Signale (oder Lichtwellen), die von den verschiedenen Sensorköpfen stammen, so dass diese Signale im Signalprozessor zu verschiedenen Zeiten ankommen und dadurch unterscheidbar sind.

Ein Nachteil eines derartigen Sensors ist, dass das erzielbare Signal-Rausch-Verhältnis nicht optimal ist, weil aufgrund des gepulsten Betriebes nicht ständig, sondern nur während eines Bruchteils der Messzeit ein Signal am Detektor erzeugt wird. Ein weiterer Nachteil ist, dass aufgrund der veschieden Längen der zwei Reflexions-Interferometer die Amplitude, mit der der Phasenmodulator betrieben wird, nur für eine der beiden Sensorfasern optimal gewählt werden kann.

Ein anderer Stromsensor ist aus G. Frosio, R. Dändliker, "Reciprocal Reflection Interferometer for a Fiber-Optic Faraday Current Sensor", Appl. Opt. 33, 61 11 (1994) bekannt. Dieser weist ebenfalls eine Reflexions-Geometrie auf, beinhaltet aber nur einen Sensorkopf. Zur Erzeugung einer nicht-reziproken differentiellen Phasenmodulation weist dieser Sensor ebenfalls einen piezoelektrischen Phasenmodulator auf. Dieser ist nicht in einem Modulatorkreis angeordnet. Er moduliert die differentielle Phase zweier sich in dieselbe Richtung ausbreitender, zueinander orthogonal polarisierter Lichtwellen. Dazu werden deutlich grössere Treiberspannungen am Piezomaterial des Modulators benötigt, da eine direkte Modulation der Doppelbrechung der Faser des Modulators erzeugt werden muss.

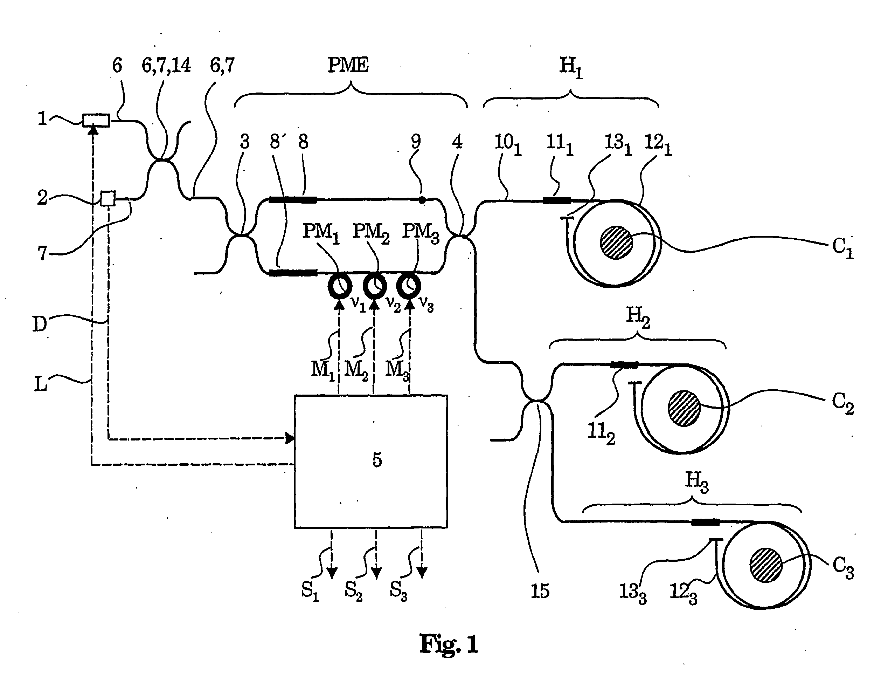

J. Blake, P. Tantaswadi, and R. T. de Carvalho offenbaren in der Figur 1 der Publikation "In-line Sagnac Interferometer Current Sensor", IEEE Transactions on Power Delivery, 11, 116-121 (1996) einen weiteren Stromsensor. Dieser Sensor weist eine Sagnac-Geometrie auf und beinhaltet nur einen Sensorkopf. Wie der von Frosio und Dändliker beschriebene Sensor muss auch hier eine grosse Treiberspannung am Piezomaterial des Modulators anliegen, da mittels direkter Modulation der Doppelbrechung die differentielle Phase zweier sich in dieselbe Richtung ausbreitender, zueinander orthogonal polarisierter Lichtwellen moduliert wird.

Darstellung der Erfindung

Es ist Aufgabe der Erfindung, einen Stromsensor der eingangs genannten Art und ein entsprechendes Messverfahren zu schaffen, wobei die oben genannten Nachteile nicht aufgewiesen werden sollen. Insbesondere soll der Sensor ein verbessertes Signal-Rausch-Verhältnis aufweisen.

Diese Aufgabe löst ein faseroptischer Stromsensor mit den Merkmalen des Patentanspruches 1 und ein entsprechendes Messverfahren gemäss Patentanspruch 12.

Der erfindungsgemässe faseroptische Sensor zur Messung mindestens eines elektrischen Stromes oder Magnetfeldes, weist auf: eine Lichtquelle; N Sensorköpfe, die spulenförmig um Stromleiter oder entlang des Magnetfeldes anordnbar sind, wobei N eine ganze Zahl mit $N \geq 2$ ist; mindestens eine Phasenmodulationseinheit mit mindestens einem Phasenmodulator; mindestens einen Detektor; und eine Steuerungs- und Auswerte-Einheit, die über mindestens eine Detektorsignalleitung mit dem mindestens einen Detektor und über mindestens eine Modulatorsignalleitung mit dem mindestens einen Phasenmodulator verbunden ist. Dabei sind erste Mittel zur Führung von Licht der Lichtquelle in ein detektorseitiges Ende der Phasenmodulationseinheit und zweite Mittel zur Führung von Licht von dem detektorseitigen Ende der Phasenmodulationseinheit zu dem Detektor vorhanden, und die mindestens eine Phasenmodulationseinheit weist ein weiteres, sensorkopfseitiges Ende auf, weiches mit mindestens einem der Sensorköpfe optisch verbunden ist, und mittels der mindestens einen Phasenmodulationseinheit sind linear polarisierte Lichtwellen nicht-reziprok differentiell phasenmodulierbar.

Der Sensor zeichnet sich dadurch aus, dass für die nicht-reziproken differentiellen Phasenmodulationen N Modulationsamplituden $\Phi_{0,n}$ und N Modulationsfrequenzen $\nu_n$ vorgesehen sind, wobei die Modulationsfrequenzen $\nu_n$ und zwei vorgebbare positive ganze Zahlen p, q mit $p \neq q$ derart gewählt sind, dass für alle positiven ganzen Zahlen z und für alle ganzen Zahlen n, m mit $n \neq m$ und $1 \leq n,m \leq N$ gilt:

$$p \cdot \nu_n \neq z \cdot \nu_m$$

und

$$q \cdot \nu_n \neq z \cdot \nu_m ,$$

und wobei die Modulationsamplituden $\phi_{0,n}$ und die Modulationsfrequenzen $\nu_n$ in Abhängigkeit von modulationsrelevanten optischen Weglängen $\ell_n$ gewählt sind.

Es werden also bei einem N Sensorköpfe umfassenden Sensor N verschiedene Modulationsfrequenzen $\nu_n$ zur nicht-reziproken Modulation der differentiellen Phase der Lichtwellen eingesetzt. Diese Modulationsfrequenzen $\nu_n$ und zwei positive ganze Zahlen p und q sind derart gewählt, dass ein p-faches und ein q-faches jeder der Modulationsfrequenzen $\nu_n$ verschieden ist von allen Harmonischen jeder der anderen Modulationsfrequenzen $\nu_n$. Ausserdem werden die Modulationsamplituden $\phi_{0,n}$ und die Modulationsfrequenzen $\nu_n$ in Abhängigkeit von modulationsrelevanten optischen Weglängen $\ell_n$ gewählt. Diese modulationsrelevanten optischen Weglängen $\ell_n$ sind im wesentlichen die optischen Weglängen, welche Lichtwellen von dem mindestens einen Phasenmodulator durch den n-ten Sensorkopf und zurück zu demselben mindestens einen Phasenmodulator durchlaufen. Korrekturen, die dieser optischen Weglänge, beispielsweise im Falle von Modulatorkreisen mit verschieden langen Faserzweigen als Phasenmodulationseinheiten, zuzufügen sind, sind weiter unten in der Beschreibung angegeben.

Vorteilhaft ist, dass aufgrund eines derartigen Aufbaus einerseits aufgrund der Bedingungen für die Modutationsfrequenzen $\nu_n$ die Signale, die von verschiedenen Sensorköpfen stammen, über ihre Frequenz eindeutig dem entsprechenden Sensorkopf zuordnbar sind. Andererseits sind die Modulationsamplituden $\phi_{0,n}$ und die Modulationsfrequenzen $\nu_n$ derart wählbar, dass eine optimale Detektierbarkeit und ein optimales Signal-Rausch-Verhältnis für jeden der N Sensorköpfe einstellbar ist.

Vorteilhaft wird $p = 1$ und $q = 2$ gewählt, so dass Signale der ersten und der zweiten Harmonischen detektiert und ausgewertet werden. Dadurch sind die detektierten Signale besonders gross, so dass das Signal-Rausch-Verhältnis optimal ist.

In einer vorteilhaften Ausführungsform der Erfindung weist der Sensor genau eine Steuerungs- und Auswerte-Einheit auf. In dieser werden Signale, die von den verschiedenen Sensorköpfen stammen und über die mindestens eine Detektorsignalleitung der Steuerungs- und Auswerte-Einheit zugeführt weden, mittels Frequenzfilterung voneinander unterschieden. Diese Signale werden in der Steuerungs- und Auswerte-Einheit in N Ausgangs-Signale $S_n$ umgwandelt, welche ein Mass für den mindestens einen zu messenden Strom oder das mindestens eine zu messende Magnetfeld sind. Insbesondere werden in der Steuerungs- und Auswerte-Einheit die Ausgangs-Signale $S_n$ für jedes n mit $1 \leq n \leq N$ aus Signalen bei den Frequenzen $p \cdot \nu_n$ und $q \cdot \nu_n$ bestimmt. Die Detektion kann in einem open-loop- oder in einem closed-loop-Verfahren stattfinden. Aufgrund der frequenzmässigen Zuordnung der Signale zu den Sensorköpfen kann eine einzige Steuerungs- und Auswerte-Einheit zur-Auswertung von Signalen aller Sensorköpfe eingesetzt werden, so dass ein sehr kostengünstiger und einfacher Sensor realisiert wird.

Eine weitere vorteilhafte Ausführungsform der Erfindung kennzeichnet sich dadurch, dass sie genau eine Phasenmodulationseinheit beinhaltet. Dadurch wird ein sehr kostengünstiger und einfacher Aufbau realisiert. Der Sensor weist N Reflexionsinterferometer auf, wobei jedes der N Reflexionsinterferometer genau einen der N Sensorköpfe beinhaltet, und wobei die N Sensorköpfe jeweils ein verspiegeltes Ende aufweisen. Ein derartiger Sensor ist unempfindlich gegen Störungen wie Vibrationen und einfach herstellbar. Ausserdem ist es möglich, eine inhärente Temperaturkompensation vorzusehen, wie sie aus dem Stand der Technik bekannt ist. Vorteilhaft wird die Lichtquelle eines solchen Sensors gepulst betrieben, und die Detektion erfolgt mittels eines Zeit-Multiplexing-Verfahrens. So kommt der Sensor mit einem Minimum an erforderlichen Komponenten aus.

Bei einem solchen Sensor ist die Phasenmodulationseinheit vorteilhaft entweder ein Modulatorkreis mit N Phasenmodulatoren, die jeweils mit einer der N Modulationsfrequenzen $\nu_n$ betrieben werden, oder die Phasenmodulationseinheit ist ein einziger Phasenmodulator, welcher eine simultane Phasenmodulation mit den N verschiedenen Modulationsfrequenzen $\nu_n$ erlaubt, also mit einem Frequenzgemisch der N Modulationsfrequenzen $\nu_n$ betrieben wird.

Eine andere vorteilhafte Ausführungsform der Erfindung weist N Phasenmodulationseinheiten mit je einem Phasenmodulator auf, wobei die n-te Phasenmodulationseinheit mit dem n-ten Sensorkopf optisch verbunden ist und der n-te Phasenmodulator mit der Modulationsfrequenz $\nu_n$ betrieben wird. Ein derartiger Sensor ist ohne ein Zeit-Multiplexing-Verfahren betreibbar, so dass die Lichtquelle kontinuierlich (im cw-Betrieb) betrieben werden kann. Dadurch ergibt sich ein verbessertes Signal-Rausch-Verhältnis.

Ein solcher Sensor ist vorteilhaft derart aufgebaut, dass N Reflexionsinterferometer aufgewiesen werden, wobei jedes der N Reflexionsinterferometer genau einen der N Sensorköpfe beinhaltet, und wobei die N Sensorköpfe jeweils ein verspiegeltes Ende aufweisen, und dass entweder die Phasenmodulationseinheiten Modulatorkreise sind, wobei durch die Phasenmodulatoren die differentielle Phase von gegenläufigen, zueinander parallel polarisierten Lichtwellen moduliert wird, oder dass durch jeden der Phasenmodulatoren die differentielle Phase von sich in dieselbe Richtung ausbreitenden, zueinander orthogonal polarisierten Lichtwellen moduliert wird, beispielsweise mittels integriert optischer Modulatoren.

Ein entsprechender Sensor kann auch in Sagnac-Konfiguration aufgebaut sein.

Ein vorteilhafter erfindungsgemässer Sensor wird vorteilhaft mit p = 1 und q = 2 betrieben, wobei die N Modulationsamplituden $\phi_{0,n}$ und die N Modulationsfrequenzen $\nu_n$ derart gewählt werden, dass Amplituden $\alpha_{0,n}$ der Modulation der differentiellen Phase der linear polarisierten Lichtwellen für alle n mit $1 \leq n \leq N$ zwischen 1.7 und 2.0, insbesondere zwischen 1.8 und 1.88, liegen oder im wesentlichen 1.84 betragen. Dies ergibt maximale Signale und ein optimales Signal-Rausch-Verhältnis.

In dem erfindungsgemässen Verfahren zur Messung mindestens eines elektrischen Stromes oder mindestens eines Magnetfeldes werden von einer Lichtquelle Lichtwellen emittiert, die in linear polarisierte Lichtwellen umgewandelt werden. Die linear polarisierten Lichtwellen werden in N Sensorköpfe geführt, in welchen die Lichtwellen eine von dem zu messenden Strom oder Magnetfeld abhängige Phasenverschiebung erfahren, wobei N eine ganze Zahl mit, $N \geq 2$ ist. Die Lichtwellen erfahren in mindestens einer Phasenmodulationseinheit mit mindestens einem Phasenmodulator eine nicht-reziproke differentielle Phasenmodulation und werden in mindestens einem Detektor detektiert. Die mindestens eine Phasenmodulationseinheit wird von den Lichtwellen sowohl bei deren Ausbreitung von der Lichtquelle zu den Sensorköpfen als auch bei deren Ausbreitung von den Sensorköpfen zu dem mindestens einen Detektor durchlaufen. Mittels einer Steuerungs- und Auswerte-Einheit wird einerseits der mindestens eine Phasenmodulator gesteuert, und andererseits werden durch sie auch von dem mindestens einen Detektor stammende Signale ausgewertet.

Das Verfahren kennzeichnet sich dadurch, dass die Lichtwellen mit N Modulationsamplituden $\phi_{0,n}$ und N Modulationsfrequenzen $\nu_n$ nicht-reziprok differentiell phasenmoduliert werden. Dabei werden die Modulationsfrequenzen $\nu_n$ und zwei vorgebbare positive ganze Zahlen p, q mit $p \neq q$ derart gewählt, dass für alle positiven ganzen Zahlen z und für alle ganzen Zahlen n, m mit $n \neq m$ und $1 \leq n,m \leq N$ gilt:

$$p \cdot \nu_n \ \neq \ z \cdot \nu_m$$

und

$$q \cdot \nu_n \ \neq \ z \cdot \nu_m \ .$$

Die Modulationsamplituden $\phi_{0,n}$ und die Modulationsfrequenzen $\nu_n$ werden vorteilhaft in Abhängigkeit von modulationsrelevanten optischen Weglängen $\ell_n$ gewählt.

Es werden, vorzugsweise mittels Frequenzfilterung, Signale der p-ten und der q-ten Harmonischen der N Modulationsfrequenzen $\nu_n$ detektiert. Die Modulationsfrequenzen $\nu_n$ werden derart gewählt, dass diese p-ten und der q-ten Harmonischen verschieden sind von anderen auftretenden Signalfrequenzen, insbesondere von den anderen Harmonischen der Modulationsfrequenzen $\nu_n$. Dies erlaubt eine eindeutige Zuordnung der Signale über ihre Frequenz zu dem entsprechenden Sensorkopf. Ausserdem erlaubt die Wahl der verschiedenen Modulationsfrequenzen $\nu_n$ für die verschiedenen Sensorköpfe, zusammen mit einer entsprechenden Wahl der Modulationsamplituden $\phi_{0,n}$ der nicht-reziproken differentiellen Phasenverschiebungen, in Abhängigkeit von modulationsrelevanten optischen Weglängen $\ell_n$ eine optimale Abstimmung dieser Werte für jeden der Sensorköpfe, so dass eine optimale Detektierbarkeit und ein optimales Signal-Rausch-Verhältnis einstellbar ist.

Weitere bevorzugte Ausführungsformen und Vorteile gehen aus den abhängigen Patentansprüchen und den Figuren hervor.

Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:

Fig. 1    einen Sensor in Reflex-Konfiguration, mit einem Modulatorkreis, drei Phasenmodulatoren und drei Sensorköpfen, schematisch;

Fig. 2    eine Veranschaulichung des zeitlichen Verlaufs von Signalen beim Zeit-Multiplexing-Verfahren;

Fig.3    einen Sensor in Reflex-Konfiguration, mit einem integriertoptischen Modulator und drei Sensorköpfen, schematisch;

Fig. 4    einen Sensor in Reflex-Konfiguration, mit drei integriertoptischen Modulatoren und drei Sensorköpfen, schematisch;

Fig. 5    einen Sensor in Reflex-Konfiguration, mit drei Modulatorkreisen mit je einem Phasenmodulator, und mit drei Sensorköpfen, schematisch;

Fig. 6    einen Sensor in Sagnac-Konfiguration, mit drei piezoelektrischen Phasenmodulatoren und drei Sensorköpfen, schematisch;

Fig. 7    einen Sensor in Reflex-Konfiguration, mit drei Modulatorkreisen mit je einem Phasenmodulator, mit drei Sensorköpfen und mit drei Detektoren, schematisch.

Die in den Zeichnungen verwendeten Bezugszeichen und deren Bedeutung sind in der Bezugszeichenliste zusammengefasst aufgelistet. Grundsätzlich sind in den Figuren gleiche oder zumindest gleichwirkende Teile mit gleichen Bezugszeichen versehen. Die beschriebenen Ausführungsbeispiele stehen beispielhaft für den Erfindungsgegenstand und haben keine beschränkende Wirkung.

Wege zur Ausführung der Erfindung

Manche aus dem Stand der Technik bekannte Details zum Aufbau ähnlicher Sensoren und zur Erzeugung nicht-reziproker differentieller Phasenmodulationen sind im folgenden nicht dargestellt und können der genannten EP 1 154 278 A2 entnommen werden.

In Fig. 1 ist eine Ausführungsform der Erfindung dargestellt. Eine als niederkohärente Lichtquelle 1 dienende Superlumineszenzdiode 1 emittiert Lichtwellen in ein erstes Mittel 6 zur Führung von Licht der Lichtquelle 1 in ein detektorseitiges Ende 3 einer Phasenmodulatiönseinheit PME. Dieses erste Mittel 6 besteht im, wesentlichen aus einem Faserkoppler 14 und gegebenenfalls zusätzlich noch ein oder zwei weiteren Faserstücken, mittels derer die Lichtquelle 1 und die Phasenmodulationseinheit PME mit gegenüberliegende Seiten des Faserkopplers 14 optisch verbunden sind.

Die Lichtquelle 1 ist vorteilhaft eine niederkohärente Lichtquelle, beispielsweise eine Lumineszenzdiode, eine Superlumineszenzdiode oder eine unter der Laserschwelle betriebene Laserdiode. Die Kohärenzlängen sind dann typischerweise von der Grössenordnung 50 $\mu$m. Eine andere mögliche Lichtquelle 1 ist eine breitbandige Faserquelle, beispielsweise eine Erbiumdotierte Faser, die vorteilhaft von einem Halbleiterlaser mit zum Beispiel 980 nm oder 1480 nm Emissionswellenlänge gepumpt werden kann.

Als Phasenmodulationseinheit PME dient in Fig. 1 ein Modulatorkreis PME. Dieser weist ein detektorseitiges Ende 3 und ein sensorkopfseitiges Ende 4 auf. Diese beiden Enden 3,4 werden von Faserkopplern 3,4 gebildet. Zwischen den beiden Enden 3,4 weist der Modulatorkreis PME zwei Faserzweige auf. In jedem der zwei Faserzweige ist ein Polarisator 8 beziehungsweise 8' angeordnet. In einem der Faserzweige ist ein 90°-Spleiss 9 als Mittel zur Änderung der Polarisationsrichtung 9 angeordnet. In dem anderen Faserzweig sind N := 3 piezoelektrische Phasenmodulatoren $PM_1, PM_2, PM_3$ hintereinander angeordnet. N ist die Anzahl der Sensorköpfe $H_1, H_2, H_3$ des Sensors. An einem Ausgang des sensorkopfseitigen Kopplers 4 ist der erste Sensorkopf $H_1$ vorgesehen. An dem anderen Ausgang des sensorkopfseitigen Kopplers 4 ist ein Faserkoppler 15 vorgesehen, an dessen zwei Ausgängen die weiteren zwei Sensorköpfe $H_2, H_3$ angeschlossen sind.

Die drei Sensorköpfe $H_1, H_2, H_3$ sind gleichartig aufgebaut. Sie weisen je eine optionale faseroptische Zuleitung $10_1, 10_2, 10_3$, je ein Phasenverzögerungselement $11_1, 11_2, 11_3$ und je eine Sensorspule $12_1, 12_2, 12_3$ auf. Im folgenden

wird der Übersichtlichkeit halber $10_n$, $11_n$ usw. geschrieben. In den Figuren sind der Übersichtlichkeit halber einige Bezugszeichen weggelassen, die sich aus dem Rest der Figur oder im Zusammenhang mit den anderen Figuren ergeben. Das Phasenverzögerungselement $11_n$ ist ein $\lambda/4$-Element, das eine 90°-Phasenverzögerung oder auch eine andere, typischerweise nahe 90° liegende Phasenverzögerung erzeugt. Es verbindet die faseroptische Zuleitung $10_n$ mit einem Ende der Sensorspule $12_n$. Die Sensorspule $12_n$ besteht aus einer magnetooptisch aktiven Faser $12_n$ mit vorzugsweise rundem Kernquerschnitt. Das andere Ende $13_n$ der Sensorspule $12_n$ ist verspiegelt oder weist einen Spiegel $13_n$ auf. Jeder Sensorkopf $H_n$ ist spulenförmig um einen Stromleiter $C_n$ angeordnet, in welchem ein zu messender elektrischer Strom $I_{el,n}$ fliesst.

Nach einer Reflexion an einem verspiegelten Ende $13_n$ laufen die Lichtwellen wieder zurück. Ab dem detektorseitigen Ende 3 der Phasenmodulationseinheit PME wird das Licht über ein zweites Mittel 7 zur Führung von Licht von dem detektorseitigen Ende 3 der Phasenmodulationseinheit PME zu einem Detektor 2 geführt.

Der Detektor 2 ist ein Photo-Detektor, beispielsweise eine Photodiode oder ein Photo-Multiplier.

Weiter weist der Sensor eine Steuerungs- und Auswerte-Einheit 5 auf, welche einen Signalprozessor beinhaltet. Die Steuerungs- und Auswerte-Einheit 5 ist über eine Detektorsignalleitung D mit dem Detektor 2 und über drei Modulatorsignalleitungen $M_n$ mit jeder der drei Phasenmodulatoren $PM_n$ verbunden. Ausserdem ist die Steuerungs- und Auswerte-Einheit 5 noch über eine Lichtsteuerungssignalleitung L mit der Lichtquelle 1 verbunden. Die Steuerungs- und Auswerte-Einheit 5 wertet die vom Detektor 2 stammenden Signale aus in Ausgangs-Signale $S_n$, die ein Mass für die Grösse der zu messenden elektrischen Ströme $I_{el,n}$ oder Magnetfelder sind.

Die zwischen den Polarisatoren 8,8' und den Phasenverzögerungselementen $11_n$ angeordneten optischen Elemente sind polarisationserhaltend. Vorteilhaft sind es optische Fasern mit einem elliptischen Kernquerschnitt. Vorteilhaft sind auch die zwischen den Polarisatoren 8,8' und der Lichtquelle 1 respektive dem Detektor 2 angeordneten optischen Elemente polarisationserhaltend. Dies gilt auch für die anderen Ausführungsformen der Erfindung.

Das von der Lichtquelle 1 emittierte Licht wird am Koppler 3 vorzugsweise im Intensitätsverhältnis 1:1 auf die zwei Faserzweige des Modulatorkreises aufgeteilt. In den Polarisatoren 8,8' wird das Licht linear polarisiert. Aufgrund des 90°-Spleisses 9 gelangen dann zueinander orthogonal polarisierte Lichtwellen in den Koppler 4. In dem 90°-Phasenverzögerungselement $11_n$ werden die zueinander orthogonal polarisierten Lichtwellen in links- und rechts-zirkular polarisierte Lichtwellen umgewandelt. Diese erfahren aufgrund des Magnetfeldes des zu messenden Stromes in der Sensorspule $12_n$ verschieden grosse Phasenverschiebungen. Nach Reflexion an dem verspiegelten Ende $13_n$ werden die zirkular polarisierten Lichtwellen beim zweiten Durchlaufen des 90°-Phasenverzögerungselements $11_n$ wieder in zueinander orthogonal polarisierte Lichtwellen umgewandelt. Diese weisen nun aufgrund des nicht-reziproken Faraday-Effekts eine differentielle Phasenverschiebung von

$$\Delta\Phi_n = 4 \cdot V_n \cdot R_n \cdot I_{el,n}$$

auf. Dabei ist $V_n$ die Verdet-Konstante des Materials einer Sensorspule $12_n$ (beispielsweise $2.65\cdot10^{-3}$ Rad /A bei 820 nm Lichtwellenlänge); $R_n$ die Anzahl Windungen der Sensorspule um einen Stromleiter; Iel,n der in dem Stromleiter $C_n$ fliessende, zu messende Strom. Dass die Phasernverschiebung nicht-reziprok ist, bedeutet, dass sie sich durch das zweimalige Durchlaufen der Sensorspule $12_n$ (davon einmal in entgegengesetzter Richtung) aufaddiert und nicht auslöscht.

Wenn die Phasenverzögerungselemente $11_n$ nicht eine genau 90° betragende Phasenverschiebung erzeugen, entsteht statt zirkular polarisiertem Licht elliptish polarisiertes Licht. Dadurch ergeben sich gegenüber der angegebenen Gleichung für $\Delta\phi_n$ entsprechende Korrekturen, die aus den Stand der Technik bekannt sind.

Die nicht-reziprok phasenverschobenen, zueinander orthogonal polarisierten Lichtwellen durchlaufen die Phasenmodulationseinheit PME. Über das zweite Mittel 7 zur Führung von Licht wird das Licht von dem detektorseitigen Ende 3 der Phasenmodulationseinheit PME zu dem Detektor 2 übertragen. Das zweite Mittel 7 ist teilweise identisch mit dem ersten Mittel 6. Es umfasst den Koppler 14 und gegebenenfalls ein oder zwei weitere Faserstücke. Als Detektor 2 dient eine Photodiode 2. Die durch den Faraday-Effekt induzierte nicht-reziproke Phasenverschiebung $\Delta\phi$ ist ein Mass für die Grösse des zu messenden elektrischen Stroms.

Der Modulatorkreis PME dient der nicht-reziproken Modulation einer differentiellen Phase zweier sich gegenläufig ausbreitender, zueinander parallel polarisierter Lichtwellen. Der effektive Arbeitspunkt der interferometer wird dadurch in einen linearen Bereich der kosinusförmigen Interferenzfunktion verschoben. Auf diese Weise wird eine grössere Auflösung bei der Detektion der durch den Faraday-Effekt induzierten differentiellen Phasenverschiebung $\Delta\phi$ erreicht.

Der Modulatorkreis PME beinhaltet, entsprechend der Anzahl N an Sensorköpfen $H_n$, drei vorzugsweise piezoelektrische Phasenmodulatoren $PM_1$, $PM_2$, $PM_3$. Ein piezoelektrischer Phasenmodulator besteht im wesentlichen aus einem Stück Piezomaterial und einem Stück optischer Faser, das um das Piezomaterial gewickelt ist. Vorteilhaft wird jeder der Phasenmodulatoren $PM_n$ bei seiner Resonanzfrequenz betrieben. Durch den Betrieb bei der Resonanzfrequenz kann bereits mit relativ kleinen Treiberspannungen eine grosse Phasenmodulationsamplitude $\phi_{0,n}$ für die einzelnen Lichtweiien erzeugt werden. Die Amplituden der differentiellen Phasenverschiebung zwischen den zwei sich gegenläufig ausbreitenden, zueinander parallel polarisierten Lichtwellen sei $\alpha_{0,n}$. Die Frequenzen der Modulationen seien $\nu_n$. Das Signal an der Photodiode 2 ist dann mit den Mpdutationsfrequenzen $\nu_n$ und deren Harmonischen moduliert.

Zunächst wird der Fall betrachtet, dass mit einem Phasenmodulator $PM_n$ und einer einzigen Modulationsfrequenz $\nu_n$ moduliert wird und es einen Sensorkopf $H_n$ gibt, also N = 1 und n = 1:

Für Faraday-Phasenverschiebungen $\Delta\phi_n < 90°$ kann $\Delta\phi_n$ aus den Amplituden $I_{Det,vn} = I_0 \cdot J_1(\alpha_{0,n}) \cdot \sin \Delta\phi_n$ der Photodioden-Signale der ersten Harmonischen $\nu_n$ beziehungsweise $I_{Det,2vn} = I_{0,n} \cdot J_2 \cdot (\alpha_{0,n}) \cdot \cos \Delta\phi_n$ der zweiten Harmonischen $2 \cdot \nu_n$ bestimmt werden gemäss

$$\Delta\Phi_n = \arctan \{[\, I_{Det,vn}/I_{Det,2vn} \,] \cdot [\, J_2(\alpha_{0,n}) \,/\, J_1(\alpha_{0,n}) \,]\} \,,$$

wobei $I_{0,n}$ konstante, im allgemeinen unbekannte Lichtamplituden, und $J_1$ und $J_2$ die Besselfunktionen erster beziehungsweise zweiter Ordnung sind.

Für kleine Faraday-Phasenverschiebungen $\Delta\phi_n$ mit $\Delta\phi_n \ll 1$ (in Radiant) gilt näherungsweise

$$\Delta\Phi_n = [\, I_{Det,vn}/I_{Det,2vn} \,] \cdot [\, J_2(\alpha_{0,n})/J_1(\alpha_{0,n}) \,] \,.$$

Die beschriebene Art der Signaldetektion und -Auswertung ist eine sogenannte open-loop-Detektion. Alternativ zur open-loop-Detektion gibt es die closed-loop-Detektion. Bei der closed-loop-Detektion wird $\Delta\phi_n$ an dem Phasenmodulator $PM_n$ durch Anlegen eines entsprechenden Regelsignals kompensiert. Dazu wird eine Amplitude des Photodiodensignals, vorzugsweise bei der ersten Harmonischen, also bei $I_{Det,vn}$, auf null geregelt. Die Grösse des Regelsignals ist ein Mass für $\Delta\phi_n$ und den zu messenden Strom $I_{el,n}$.

Die Modulationsamplituden $\alpha_{0,n}$ der differentiellen Phasen sind gegeben durch

$$\alpha_{0,n} = 2 \cdot \Phi_{0,n} \cdot \sin (2\pi\nu_n T_n/2) \,,$$

wobei $T_n$ die modulationsrelevante Umlaufzeit des Lichtes ist. $T_n$ ist gegeben als $T_n = \ell_n/c$ mit der modulationsrelevanten optischen Weglänge $\ell_n$ und der Vakuumlichtgeschwindigkeit c. Die optische Weglänge ist das Produkt aus der geometrischen Weglänge und dem effektiven Brechungsindex. Wenn der optische Aufbau derart gestaltet ist, dass eine Lichtwelle sowohl vor dem Durchlaufen des n-ten Sensorkopfes $H_n$ als auch nach dem Durchlaufen des n-ten Sensorkopfes $H_n$ in dem n-ten Phasenmodulator $PM_n$ moduliert wird, ist $T_n$ die Zeit, die eine Lichtwelle braucht, wenn sie vom n-ten Modulator $PM_n$ bis durch den n-ten Sensorkopf $H_n$ und wieder zurück zum n-ten Modulator $PM_n$ läuft. $\ell_n$ ist die entsprechende optische Weglänge. Im Falle eines reflektiven Aufbaus mit einem einen Phasenmodulator $PM_n$ beinhaltenden Modulatorkreis $PME_n$, dessen Faserzweige beide dieselbe optische Länge haben, ist die modulationsrelevante Umlaufzeit $T_n$ das Zweifache der Zeit, die eine Lichtwelle braucht, wenn sie von dem Phasenmodulator $PM_n$ bis zum Spiegel $13_n$ des Sensorkopfes $H_n$ braucht (auf dem Rückweg läuft eine auf dem Hinweg phasenmodulierte Welle durch den Faserzweig der Phasenmodulationseinheit, der den Phasenmodulator nicht enthält). Entsprechend ist $\ell_n$ dann das Zweifache der optischen Weglänge von dem Phasenmodulator $PM_n$ bis zum Spiegel $13_n$ des Sensorkopfes $H_n$. In dem Fall, dass der Modulatorkreis $PME_n$ zwei verschieden lange Faserzweige hat, muss, um $\ell_n$ zu erhalten, zu dieser optischen Weglänge noch diejenige optische Differenz-Weglänge hinzuaddiert werden, um die der zweite Faserzweig länger ist der erste, den Phasenmodulator $PM_n$ enthaltende Faserzweig. Diese aufzuaddlerende Differenz-Weglänge ist, wenn der zweite Faserzweig kürzer ist als der den Phasenmodulator $PM_n$ enthaltende, negativ. Entsprechend verhält es sich bei unterschiedlich langen Faserzweigen mit der modulationsrelevanten Umlaufzeit $T_n$: Zu dem Zweifachen der Zeit, die eine Lichtwelle von dem Phasenmodulator $PM_n$ bis zum Spiegel $13_n$ des- Sensorkopfes $H_n$ braucht, muss noch eine (positive oder negative) Differenzzeit aufaddiert werden für die genannte Differenz-Weglänge.

Bei einer gegebenen Treiberspannung eines Phasenmodulators $PM_n$ und einer daraus resultierenden Amplitude $\phi_{0,n}$ der Phasenmodulation ist, gemäss der obigen Gleichung, $\alpha_{0,n}$ maximal für

$$\ell_n = (2p-1) \cdot c/(2\nu_n), \qquad \text{mit } p = 1,2,3\dots \,.$$

$\alpha_{0,n}$ wird hingegen Null für

$$\ell_n = p \cdot c/(2\nu_n), \qquad \text{mit } p = 1,2,3\dots\,.$$

Die Modulationsamplituden $\phi_{0,n}$ und die Modulationsfrequenzen $\nu_n$ werden für alle n in Abhängigkeit von der jeweiligen optischen Weglänge $\ell_n$ gewählt. Dabei sind die Modulationsfrequenzen $\nu_n$ meist vorteilhaft dadurch vorgegeben, dass sie (im Falle piezoelektrischer Phasenmodulatoren) als Resonanzfrequenz des entsprechenden Phasenmodulators $PM_n$ gewählt werden.

Nun zum Fall $N \geq 2$, also mehrere Sensorköpfe und mehrere Modulationsfrequenzen:

Für $N \geq 2$ kommt als eine weitere Randbedingung hinzu, dass Lichtwellen, die den n-ten Sensorkopf $H_n$ durchlaufen haben, am Detektor 2 inkohärent sind mit Lichtwellen, die den m-ten Sensorkopf $H_m$ durchlaufen haben, für $n \neq m$. Die entsprechenden Lichtwellen sind dadurch nicht Interferenzfähig, so dass störende Überlagerungen und wechselseitige Beeinflussungen vermieden werden. Erzielt wird diese Bedingung durch eine entsprechende Wahl der optischen Gesamtumlauflängen $\Lambda_n$, die Lichtwellen von der Lichtquelle 1 durch den n-ten Sensorkopf $H_n$ zum Detektor 2 (oder $2_n$) zurücklegen.

Ferner wird vorteilhaft auch noch die im allgemeinen wesentlich strengere Bedingung eingehalten, dass der Term $(\Lambda_n-\Lambda_m)\cdot\Delta n_{gr}$ für $n \neq m$ deutlich grösser als die Kohärenzlänge der Lichtquelle 1 ist. Dabei ist $\Delta n_{gr}$ die Differenz der Gruppenbrechungsindizes für die zwei zueinander orthogonalen Lichtmoden. Durch Einhalten dieser Bedingung vermeidet man, dass Lichtwellen, die durch unerwünschte Modenkopplung entstanden sind, zu störenden Interferenzsignalen führen.

Am Detektor 2 kommen Signale an, welche durch den n-ten Phasenmodulator $PM_n$ moduliert sind und von dem m-ten Sensorkopf $H_m$ kommen; $1 \leq n,m \leq N$. Solche Signale $I_{Det,m,\nu n}$ bei der ersten Harmonischen $(\nu_n)$ und $I_{Det,m,2\nu n}$ bei der zweiten Harmonischen $(2\nu_n)$ sind gegeben durch

$$I_{Det,m,\nu n} = J_1(\alpha_{0,n}) \cdot \sin \Delta\Phi_m \cdot \sin(2\pi\nu_n t)$$

$$I_{Det,m,2\nu n} = J_2(\alpha_{0,n}) \cdot \cos \Delta\Phi_m \cdot \sin(4\pi\nu_n t)\,.$$

Die Treiberspannungen der Phasenmodulatoren $PM_n$ und damit die Phasenmodulationsamplituden $\phi_{0,n}$ werden in Verbindung mit den entsprechenden Modulationsfrequenzen $\nu_n$ in Abhängigkeit von den optischen Weglängen $\ell_m$ gewählt. Insbesondere werden $\phi_{0,n}$ und $\nu_n$ vorzugsweise derart gewählt, dass für $n = m$ jede der Amplituden $\alpha_{0,n}$ der Modulation der differentiellen -Phase den Wert $\alpha_{0,n} = 1.84$ hat. Bei dem Wert 1.84 (in Radiant) liegt das erste Maximum der ersten Besselfunktion $J_1$. Auf diese Weise kann ein optimales Signal-Rausch-Verhältnis erzielt werden, und zwar für die Signale von jedem der Sensorköpfe $H_m$. Für $n \neq m$ ist $\alpha_{0,n}$, abhängig von den optischen Weglängen, im allgemeinen von dem optimalen Wert (1.84) verschieden.

Die Signale $I_{Det,m,\nu n}$ und $I_{Det,m,2\nu n}$ bei den Frequenzen $\nu_n$ beziehungsweise $2 \cdot_n$ sind in der Steuerungs- und Auswerte-Einheit 5 mittels Frequenzfilterung voneinander separierbar. Dazu werden die Modulationsfrequenzen $\nu_n$ derart gewählt, dass

$$\nu_i \neq \nu_j$$

und

$$2 \cdot \nu_i \neq \nu_j\,,$$

gilt, wobei i, j ganze Zahlen mit $i \neq j$ und $1 \leq i,j \leq N$ sind, wobei N die Anzahl Sensorköpfe $H_n$ des Sensors bezeichnet, welche in dem Ausführungsbeispiel von Fig. 1 als $N = 3$ gewählt ist.

Es ist grundsätzlich auch möglich, bei der Bestimmung der Faraday-Phasenverschiebung $\Delta\phi_n$ statt mit den ersten und den zweiten Harmonischen alternativ oder zusätzlich mit anderen Harmonischen zu arbeiten, um den zu messenden Strom zu bestimmen, beispielsweise mit der dritten und vierten. Die Bedingungen für die Wahl der Modu-

lationsfrequenzen $\nu_n$ sind dann entsprechend anzupassen, so dass keine der benutzten Harmonischen mit einer anderen Frequenz oder deren Harmonischen zusammenfällt. Analog zu der obigen Gleichung gilt dann also für alle positiven ganzen Zahlen z

$$p \cdot \nu_i \quad \neq \quad z \cdot \nu_j$$

und

$$q \cdot \nu_i \quad \neq \quad z \cdot \nu_j \, ,$$

wobei i, j ganze Zahlen mit $i \neq j$ und $1 \leq i,j \leq N$ sind und p und q voneinander verschiedene, positive ganze Zahlen sind. Detektion findet dann statt bei den p-ten und q-ten Harmonischen der Modulationsfrequenzen $\nu_n$.

Da in einem Aufbau gemäss Fig. 1 jede Lichtwelle, die von einem der drei Sensorköpfe $H_n$ stammt, mit allen drei Phasenmodulatoren $PM_n$ moduliert wird, bedarf es einer Möglichkeit, diese Signale in der Steuerungs- und Auswerte-Einheit 5 voneinander zu trennen und den jeweiligen zu messenden Strömen zuzuordnen. Dazu wird ein Zeit-Multiplexing-Verfahren verwendet, durch welches die Signale von den verschiedenen Sensorköpfen $H_n$ zeitlich diskriminierbar werden.

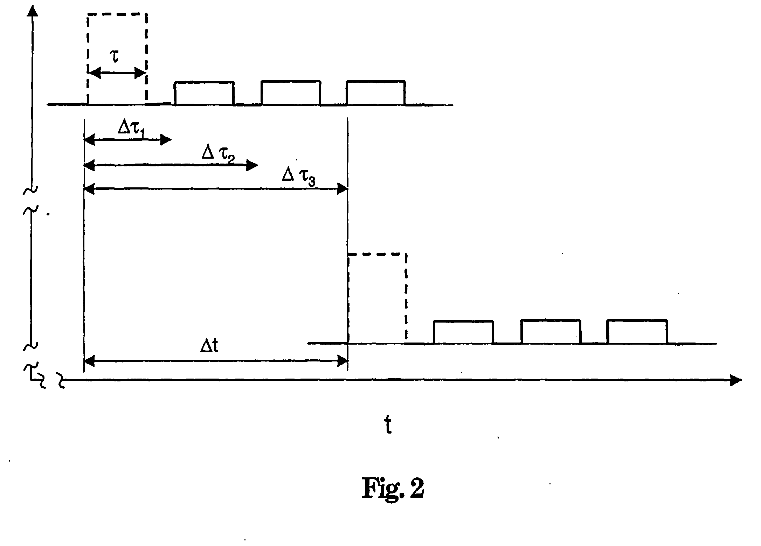

Fig. 2 veranschaulicht schematisch für das Ausführungsbeispiel von Fig. 1 den zeitlichen Verlauf der Signale. Die horizontale Achse ist die Zeitachse t.

Die vertikale Achse veranschaulicht Lichtintensitäten am Detektor 2 (durchgezogene Linien) und an der Lichtquelle 1 (gestrichelte Linien). Die Lichtquelle 1 wird gepulst betrieben mit einer Pulsdauer T und einer Pulsabstand $\Delta t$. Die Steuerung der Lichtquelle erfolgt über die Lichtsteuerungssignalleitung L mittels der Steuerungs- und Auswerte-Einheit 5. Die optischen Gesamtumlauflängen $\Lambda_n$, die Lichtwellen von der Lichtquelle 1 durch den n-ten Sensorkopf $H_n$ zum Detektor 2 zurücklegen, sind derart gewählt, dass Pulse, die von verschiedenen Sensorköpfe durchlaufen, an der Photodiode 2 zeitlich getrennt sind. Die Gesamtumlauflängen $\Lambda_n$ müssen sich dazu um mehr als $C \cdot T$ unterscheiden. Für eine Pulsdauer von beispielsweise $\tau = 1$ $\mu s$ müssen die Weglängenunterschiede (hin- und zurück zusammen) grösser als etwa 200 m sein und können beispielsweise 300 m betragen. Die optische Weglänge für die nächstliegende Spule, also das kleinste $\Lambda_n$, kann jedoch kleiner als $C \cdot \tau$ sein. Die interferierenden optischen Signale von einzelnen Sensorköpfen $H_n$ erreichen die Photodiode 2 dann in entsprechenden Zeitfenstern, also zeitlich beabstandet. Pro von der Lichtquelle 1 emittiertem Lichtpuls werden bei N Sensorköpfen genau N Pulse mit zeitlichen Verzögerungen $\Delta\tau_n$ registriert, n = 1, 2, ...N ($\Delta\tau_n$ gemessen ab Erzeugung des Lichtpulses in der Lichtquelle 1). Jeder am Detektor ankommende Lichtpuls enthält Signale, die mit allen Modulationsfrequenzen $\nu_n$ und deren Harmonischen moduliert sind.

In Fig. 2 ist der Fall dargestellt, dass die Strecken gemäss $\Lambda_n = n \cdot \Lambda_1$ gestaffelt sind. Die Weglängenunterschiede zwischen der n-ten Gesamtumlauflängen $\Lambda_n$ und der (n+1)-ten Weglänge $\Lambda_{n+1}$ beträgt also genau $\Lambda_1$. Für $\Lambda_1 = 300$ m betragen die Zeitverzögerungen der Pulse am Detektor 2 dann $\Delta\tau_n = n \cdot 1.5$ $\mu s$. Der zeitliche Abstand $\Delta t$ der emittierten Pulse (Pulsabstand $\Delta t$) muss in diesem Fall mindestens $\Delta t \geq \tau_N = N \cdot \tau_1$ betragen, entsprechend 4.5 $\mu s$ im genannten und dargestellten Beispiel. Es ist offensichtlich, dass eine Pulsdauer $\tau$, die wesentlich länger als 1 $\mu s$ ist, den Nachteil sehr langer Faserstrecken mit sich bringt. Die Weglängenunterschiede $\Lambda_{n+1} - \Lambda_n$ müssen zusätzlich noch die Bedingung erfüllen, länger als die Kohärenzlänge des Lichtes der Lichtquelle 1 zu sein.

Typische Modulationsfrequenzen $\nu_n$ sind, als Resonanzfrequenzen von Piezokristallen, von der Grössenordnung 10 kHz bis mehrere 100 kHz. Damit ist eine typische Pulsdauer $\tau$ eines Laserpulses von etwa 1 $\mu s$ deutlich kürzer als die Periodendauer $1/\nu_n$ respektive $1/(2\nu_n)$ der Signale $I_{Det,m,\nu n}$ und $I_{Det,m,2\nu n}$. Um eine oder mehrere Perioden der Signale $I_{Det,m,\nu n}$ und $I_{Det,m,2\nu n}$ abzutasten ist deshalb eine entsprechend grosse Anzahl von Pulsen notwendig, und die Wiederholfrequenz der Pulse $1/\Delta t$ muss sich von $\nu_n$ und $2\nu_n$ unterscheiden.

Höhere Modulationsfrequenzen $\nu_n$, im 1 MHz- bis über 10 MHz-Bereich, können mit integriert-optischen Modulatoren $PM_n$, beispielsweise auf Lithium-Niobat-Substraten, erzielt werden, oder mit Hilfe von Fasersegmenten, die mit einer piezoelektrischen Beschichtung versehen sind. Innerhalb eines Lichtpulses können dann eine oder mehrere Perioden der Signale $I_{Det,m,\nu n}$ und $I_{Det,m,2\nu n}$ abgetastet werden.

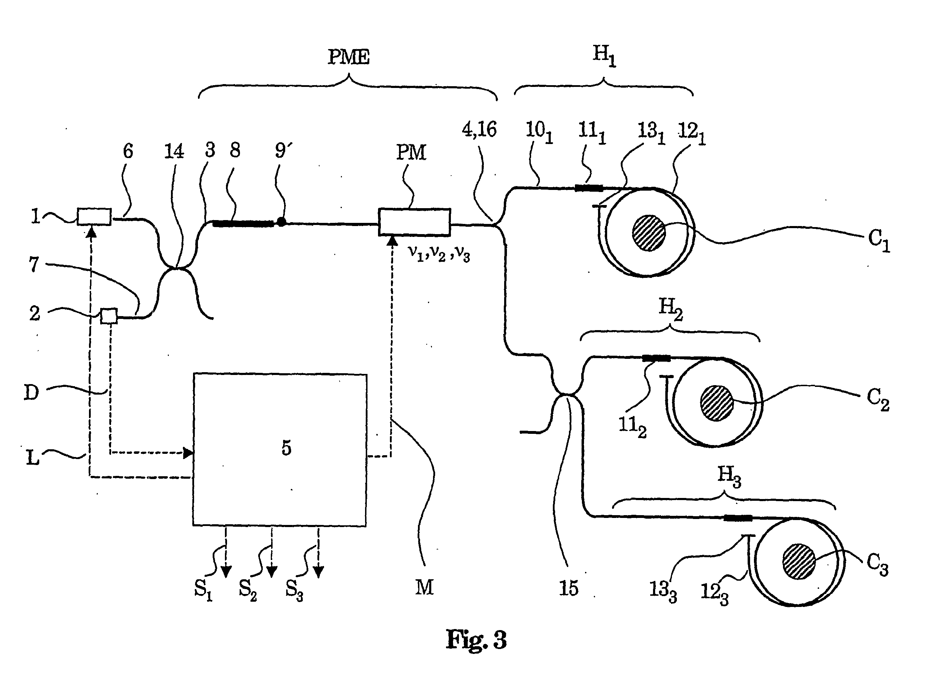

In Fig. 3 ist eine weitere vorteilhafte Ausführungsform der Erfindung dargestellt. Sie entspricht weitgehend der in Fig. 1 dargestellten Ausführungsform und wird ausgehend davon beschrieben. Im wesentlichen ist hier der Modulatorkreis PME durch eine Phasenmodulationseinheit PME ersetzt, welche einen integriert-optischen Modulator PM als Phasenmodulator PM enthält. Die Phasenmodulationseinheit PME enthält weiter einen (einzigen) Faserpoiarisator 8, der mit dem Koppler 14 optisch verbunden ist, und einen zwischen dem Polarisator 8 und dem integriert-optischen Modulator PM angeordneten 45°-Spleiss 9'. Der faserpolarisator 8 dient der linearen Polarisierung der Lichtwellen. Der 45°-Spleiss 9' erzeugt zueinander orthogonal polarisierte Lichtwellen. Das sensorkopfseitige Ende 4 der Phasenmodulationseinheit PME wird vorzugsweise von einem (asymmetrischen) 1 x2-Faserkoppler 16 gebildet.

Alternativ, aber in Fig. 3 nicht dargestellt, kann der integriert-optische Phasenmodulator PM derart ausgebildet sein, dass er nicht nur die Phasenmodulation erzeugt, sondern auch noch die Aufgabe des Faserkopplers 16 übernimmt, also die Lichtwellen aufspaltet in zwei Lichtwellenzüge, einer für den ersten Sensorkopf $H_1$ und einen für die weiteren zwei Sensorköpfe $H_2$, $H_3$.

Anstelle von drei Modulatorsignalleitungen $M_n$ bedarf es für den nur einen Phasenmodulator PM nur einer Modulatorsignalleitung M.

Von der Steuerungs- und Auswerte-Einheit 5 wird dem integriert-optischen Modulator PM ein Modulatorsignal übermittelt, das eine simultane Phasenmodulation mit N verschiedenen Modulationsfrequenzen $\nu_n$ erlaubt, wobei in Fig. 3 N = 3 ist. Das Modulatorsignal ist dann ein Frequenzgemisch oder eine Überlagerung der N Frequenzen $\nu_n$. Der integriert-optische Phasenmodulator moduliert die Phasen von zueinander orthogonal polarisierten Lichtwellen, die sich in dieselbe Richtung ausbreiten, durch direkte Modulation der Doppelbrechung.

Da im Ausführungsbeispiel von Fig. 3, wie auch im Ausführungsbeispiel von Fig. 1, nur eine Phasenmodulationseinheit PME vorgesehen ist, durch welche Lichtwellen von allen drei Sensorköpfen $H_n$ phasenmoduliert werden, wird auch dieser Sensor in einem Zeit-Multiplex-Verfahren betrieben, beispielsweise mit dem im Zusammenhang mit Fig. 1 und 2 beschriebenen Verfahren.

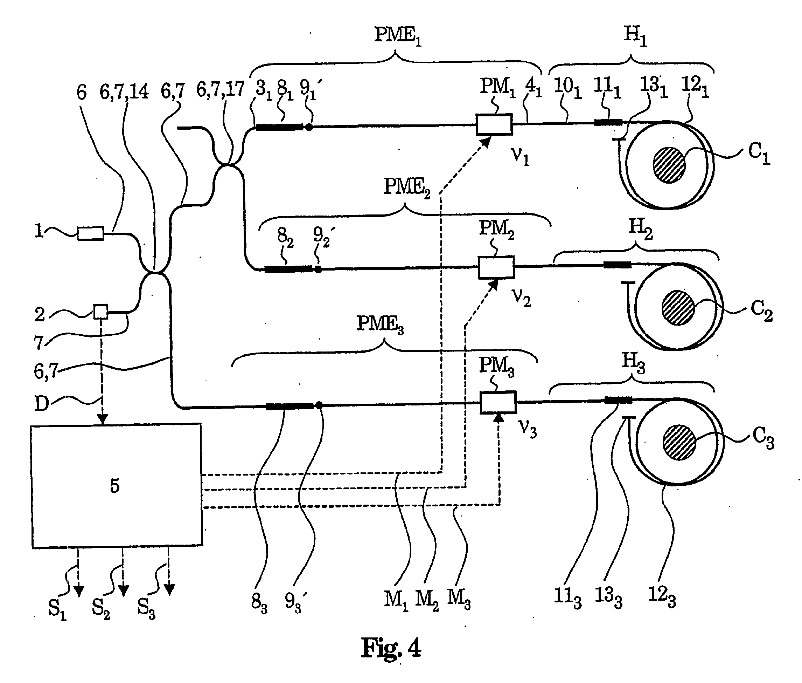

Fig.4 zeigt eine weitere vorteilhafte Ausführungsform der Erfindung. Es handelt sich wieder um einen Sensor mit einer Lichtquelle 1, einem Detektor 2, einer Steuerungs- und Auswerte-Einheit 5 und N = 3 Sensorköpfen $H_n$ in Reflex-Konfiguration. Allerdings weist der Sensor N = 3 Phasenmodulationseinheiten $PME_n$ mit je einem Phasenmodulator $PM_n$ auf. Die drei Sensorköpfe $H_n$ sind gleichartig aufgebaut. Ihr Aufbau entspricht dem der im Zusammenhang mit Fig. 1 beschriebenen Sensorköpfe. Jede der drei Phasenmodulationseinheiten $PME_n$ ist so aufgebaut wie die im Zusammenhang mit Fig. 3 beschriebene Phasenmodulationseinheit. Mittels jedem der Phasenmodulatoren $PM_n$ ist also die differentielle Phase von sich in dieselbe Richtung ausbreitenden, zueinander orthogonal polarisierten Lichtwellen modulierbar. Dies geschieht mittels einer direkten Modulation der Doppelbrechung. Die Phasenmodulatoren $PM_n$ sind vorteilhaft als integriert-optische Phasenmodulatoren $PM_n$ ausgebildet.

Über erste Mittel 6 zur Führung von Licht der Lichtquelle 1 in die detektorseitigen Enden $3_n$ der Phasenmodulationseinheiten $PME_n$ wird Licht in jede der drei Phasenmodulationseinheiten $PME_n$ geführt. Diese ersten Mittel 6 beinhalten zwei Faserkoppler 14 und 17 und gegebenenfalls weitere Faserstücke. Die Faserkoppler 14,17 sind vorteilhaft derart ausgebildet, dass in jede der Phasenmodulationseinheiten $PME_n$ im wesentlichen die gleiche Lichtintensität eingekoppelt wird. Jede der Phasenmodulationse-inheiten $PME_n$ ist an ihrem sensorkopfseitigen Ende $4_n$ mit je einem Sensorkopf $H_n$ optisch verbunden. Über zweite Mittel 7 zur Führung von Licht von den detektorseitigen Enden $4_n$ der Phasenmodulationseinheiten $PME_n$ zu dem Detektor 2 wird Licht, das von den Sensorköpfen $H_n$ zurückkommt, dem Detektor 2 zugeführt. Diese zweiten Mittel 7 beinhalten die zwei Faserkoppler 14 und 17 und gegebenenfalls weitere Faserstücke.

Dadurch, dass in der n-ten Phasenmodulationseinheit $PME_n$ nur diejenigen Lichtwellen phasenmoduliert werden, die in dem n-ten Sensorkopf $H_n$ eine Faraday-Phasenverschiebung $\Delta\phi_n$ erfahren haben, ist in einem Aufbau gemäss Fig.4 kein Zeit-Multiplexing-Verfahren zur Auswertung notwendig. Das Signal von dem n-ten Sensorkopf $H_n$ ist mit der jeweiligen Modulationsfrequenz $\nu_n$ moduliert und kann darum in der Steuerungs- und Auswerte-Einheit 5 mittels Zuordnung der Frequenzen oder durch Frequenz-Filterung eindeutig zugeordnet werden. Die Lichtquelle 1 kann im cw-Mode, also kontinuierlich, betrieben werden. Dadurch wird ein deutlich verbessertes Signal-Rausch-Verhältnis erreicht. Eine Lichtsteuerungssignalleitung L ist in einem derartigen, cw-betriebenen Sensor nicht notwendig.

Wie in den obigen Ausführungsbeispielen sind auch in einem Sensor gemäss Fig. 4 die optischen Gesamtumlauflängen $\Lambda_n$ derart gewählt, dass störende Überlagerungen und wechselseitige Beeinflussungen vermieden werden: Die N Gesamtumlauflängen $\Lambda_n$, unterscheiden sich also um mindestens die Kohärenzlänge der Lichtquelle 1. Und vorteilhaft wird auch noch die Bedingung eingehalten, dass der Term $(\Lambda_n - \Lambda_m) \cdot \Delta n_{gr}$ für $n \neq m$ deutlich grösser als die Kohärenzlänge der Lichtquelle 1 ist.

Da je eine Modulationsfrequenz $\nu_n$ pro Sensorkopf $H_n$ wählbar ist, kann diese jeweils so gewählt werden, dass eine optimale Amplitude $\alpha_{0,n}$ der Modulation der differentiellen Phase und somit ein optimales Signal-Rausch-Verhältnis erzielt wird.

Sensoren mit integriert-optischen Phasenmodulatoren werden vorteilhaft mit closed-loop-Detektion betrieben. Die Kehrwert der halben Modulationsfrequenz $\nu_n$ entspricht in diesem Fall der modulationrelevanten Umlaufzeit $T_n$ des Lichts, und die Faraday-Phasenverschiebung $\Delta\phi_n$ wird am Modulator kompensiert.

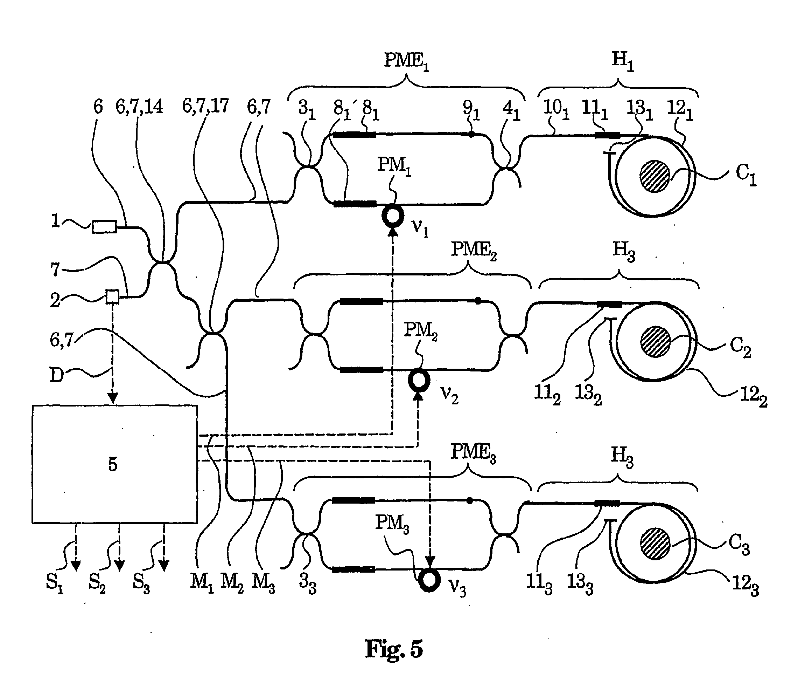

Fig. 5 zeigt eine weitere Ausführungsform, welche der Ausführungsform aus Fig. 4 ähnlich ist und ausgehend davon beschrieben wird. Statt der Phasenmodulationseinheiten $PME_n$ mit integriert-optischen Phasenmodulatoren $PM_n$ sind in Fig. 5 als Phasenmodulationseinheiten $PME_n$ Modulatorkreise $PME_n$ mit piezoelektrischen Phasenmodulatoren $PM_n$ vorgesehen. Die Modulatorkreise $PME_n$ sind im Zusammenhang mit Fig. 1 und in der genannten EP 1 154 278 A2 beschrieben. Jeder der Phasenmodulatoren $PM_n$ moduliert die differentielle Phase zweier sich gegenläufig ausbreitender, parallel zueinander polarisierter Lichtwellen.

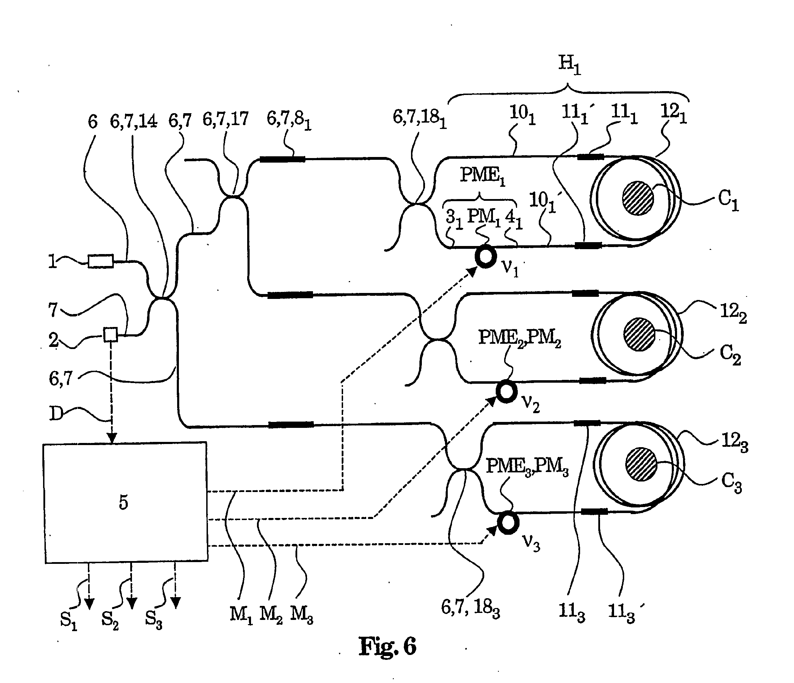

Fig. 6 zeigt einen Stromsensor mir N = 3 Sensorköpfen $H_n$ in Sagnac-Konfiguration. Die drei Sensorköpfe $H_n$ bilden also, zusammen mit einem Teil des restlichen optischen Aufbaus des Sensors, je ein Sagnac-Interferometer. Der Aufbau wird ausgehend von dem Aufbau in Fig. 4 beschrieben. Gegenüber Fig.4 sind in Fig. 6 die drei Phasenmodulationseinheiten $PME_n$, die drei Sensorköpfe $H_n$ und die Mittel 6,7 zur Führung von Licht andersartig aufgebaut. Die Sensorköpfe $H_n$ weisen zwei Zuleitungsfasern $10_n$, $10_n'$ und kein verspiegeltes Ende auf. Jede der Phasenmodulationseinheiten $PME_n$ besteht im wesentlichen aus je einem Phasenmodulator $PM_n$, welcher beispielsweise ein integriert-optischer Phasenmodulator $PM_n$ oder, wie in Fig. 6 dargestellt, ein piezoelektrischer Phasenmodulator $PM_n$ sein kann. Auf die Faserpolarisatoren $8_n$, welche Teil der Mittel 6,7 zur Führung von Licht sind, folgt kein gedrehter Spleiss, sondern ein einfacher, nicht rotierter Spleiss, der darum nicht dargestellt ist. Die ersten Mittel 6 und zweiten Mittel 7 beinhalten Faserkoppler $18_n$. Mit einem der sensorkopfseitigen Ausgangsenden des Kopplers $18_n$ ist die Zuleitungsfaser $10_n$ des Sensorkopfes $H_n$ optisch direkt verbunden. Das andere sensorkopfseitige Ausgangsende des Kopplers $18_n$ ist mit der Phasenmodulationseinheit $PME_n$ respektive dem Phasenmodulator $PM_n$ optisch verbunden. Die Phasenmodulationseihheit $PME_n$ wiederum ist mit der Zuleitungsfaser $10_n'$ des Sensorkopfes $H_n$ optisch verbunden. Für einen Abstand $\delta$ des Phasenmodulators $PM_n$ vom Koppler $18_n$ gilt vorteilhaft, dass $\Delta n_{gr} \cdot \delta$ kleiner als die Kohärenzlänge des Lichtes der Lichtquelle 1 ist, wobei $\Delta n_{gr}$ die Differenz der Gruppenbrechungsindizes für die zwei zueinander orthogonalen Lichtmoden ist.

Bei einem solchen Sensor mit Sagnac-Konfiguration werden von jedem der N Phasenmodulatoren $PM_n$ sich in entgegengesetzte Richtungen ausbreitende, zueinander parallel polarisierte Lichtwellen phasenmoduliert.

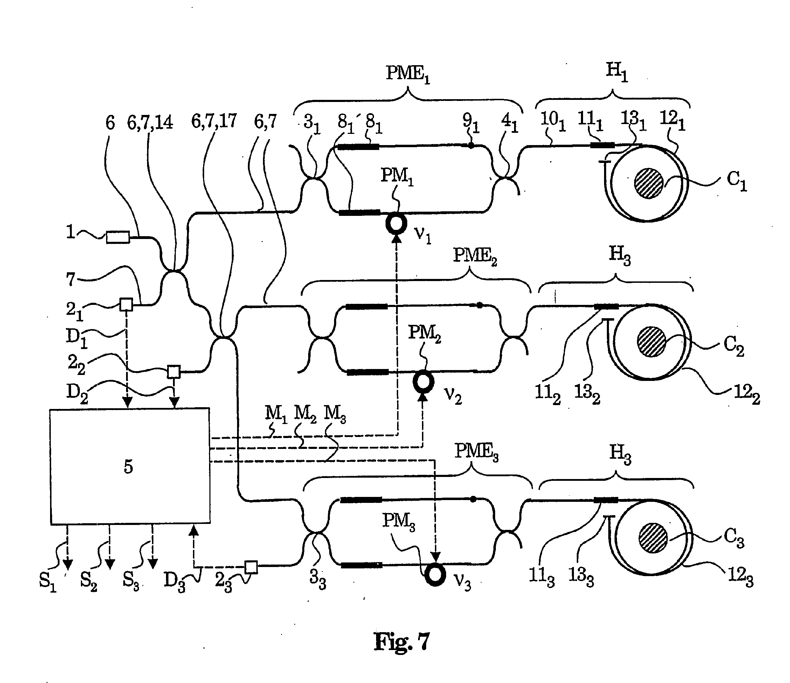

Fig. 7 zeigt eine weitere vorteilhafte Ausführungsform der Erfindung. Dieser Sensor ist ähnlich dem in Fig. 5 dargestellten Sensor und wird ausgehend von diesem beschrieben. Statt eines Detektors 2 weist der Sensor gemäss Fig. 7 N = 3 Detektoren $2_n$ auf. Diese sind jeweils an einem, dem jeweiligen Sensorkopf $H_n$ abgewandten Arm der Koppler 14, 17 und $3_3$ angeordnet. Jeder Detektor $2_n$ ist über eine Detektorsignalleitung $D_n$ mit der Steuerungs- und Auswerte-Einheit 5 verbunden. Jeder der drei Detektoren $2_n$ dient der Detektion der von dem jeweiligen Sensorkopf $H_n$ stammenden Signale. Die entsprechenden Lichtwellen passieren somit, im Vergleich zu einem Fig. 5-gemässen Aufbau, weniger Koppler. Dadurch findet weniger Intensitätsverlust statt, und es können höhere optische Leistungen detektiert werden. Das führt zu einem besseren Signal-Rausch-Verhältnis. In analoger Weise können auch die anderen diskutierten Ausführungsformen mit N Detektoren $2_n$ versehen werden.

Um eine nahezu perfekte Reziprozität und damit messtechnische Stabilität des Sensors zu erreichen, sind die Detektoren $2_n$ an den genannten Kopplern angeordnet. Die Detektoren $2_1$ und $2_2$ sind in Fig. 7 an einem reziproken Ausgang angeordnet, nicht aber der Detektor $2_3$. Ein alternativer Aufbau (nicht dargestellt), bei dem mehr Lichtleistung detektierbar ist, ergibt sich, wenn, analog zum Detektor $2_3$, jeder der Detektoren $2_n$ an dem jeweiligen Koppler $3_n$ angeordnet ist, wobei dann jeder der Detektoren $2_n$ an einem nicht-reziproken Ausgang angeordnet ist.

Bei den Modulationskreisen PME, $PME_n$ kann das Mittel zur Änderung der Polarisationsrichtung 9 mit keinem, einem oder mehreren Phasenmodulatoren PM, $PM_n$ in demselben Faserzweig angeordnet sein. Wenn mehrere Phasenmodulatoren in einem Modulationskreis angeordnet sind, können diese beliebig auf die zwei Faserzweige verteilt sein. In einem Modulatorkreis können auch zwei oder mehr, mit derselben Frequenz $\nu_n$ betriebene Phasenmodulatoren einen einzigen mit dieser Frequenz $\nu_n$ betriebene Phasenmodulator ersetzen. Diese Phasenmodulatoren können in demselben oder in verschiedenen Faserzweigen des Modulatorkreises angeordnet sein.

In einem Aufbau mit Sagnac-Konfiguration, wie beispielsweise in Fig. 6, könnten statt nur eines Phasenmodulators $PM_n$ auch mehrere Phasenmodulatoren $PM_n$ pro Sensorkopf $H_n$ angeordnet sein. Eine Anordnung an demselben oder an verschiedenen Enden der jeweiligen Sensorspule $12_n$ wäre möglich.

Grundsätzlich sind in den diskutierten Ausführungsbeispielen vorteilhaft die Teilerverhältnisse der Koppler derart gewählt, dass in jeden Sensorkopf $H_n$ im wesentlich die gleiche Lichtintensität eingekoppelt wird.

Grundsätzlich sind in dein diskutierten Ausführungsbeispielen vorteilhaft die Anzahl und Anordnung der Koppler derart gewählt, dass die Reziprozität für alle Lichtwege gegeben ist. Das heisst, dass durch den Aufbau des Sensors keine nicht-reziproken Phasenverschiebungen auftreten, sondern nur die zu detektierende nicht-reziproke Faraday-Phasenverschiebung $\Delta\phi_n$ und die quasi-statische, durch die Phasenmodulation hervorgerufene Phasenverschiebung für die effektive Verschiebung des Arbeitspunktes bei der Detektion und Auswertung. Beispielsweise wäre der Aufbau gemäss Fig. 1 nicht mehr reziprok und somit anfällig für Störeinflüsse (mechanisch, thermisch), wenn die zwei Koppler 14 und 3 durch einen einzigen Koppler ersetzt würden.

Es ist grundsätzlich auch möglich, statt zweier seriell geschalteter Koppler einen einzelnen Koppler zu verwenden, der einen oder zwei Lichtwege in mehr als zwei Lichtwege koppelt. Beispielsweise in Fig. 1 würden dementsprechend die Koppler 4 und 15 durch einen 2×3-Koppler ersetzt, der also zwei Eingänge und drei Ausgänge hat, wobei an jeden der drei Ausgänge über je eine optische Zuleitung $10_n$ je ein Sensorkopf $H_n$ gekoppelt wäre. Dies bedingt aber eine ausreichende Polarisationserhaltung des Kopplers.

Selbstverständlich können verschiedene Typen der beschriebenen Phasenmodulationseinheiten PME sowie der Phasenmodulatoren PM in einem Sensor kombiniert werden. Es sind ausserdem auch Phasenmodulatoren denkbar, die von piezoelektrischen und integriert-optischer Phasenmodulatoren verschieden sind.

Vorteilhaft an den beschriebenen Sensoren ist, dass sie nur eine einzige Steuerungs- und Auswerte-Einheit 5 oder nur einen einzigen Signalprozessor benötigen. Weiter vorteilhaft ist, dass nur eine einzige Lichtquelle 1 benötigt wird. Weiter vorteilhaft ist, dass es möglich ist, mit nur einem einzigen Detektor 2 auszukommen. Alle diese Vorteile resultieren in einem einfachen und kostengünstigen Aufbau des Sensors.

Erfindungsgemässe Sensoren können zur Messung von N Strömen oder N Mangetfeldern benutzt werden. Es ist auch möglich, einen Teil der Sensorköpfe $H_n$ redundant einzusetzen. Beispielsweise bei N = 6 Sensorköpfen $H_n$ können vorteilhaft je zwei Sensorköpfe denselben Strom einer Phase eines elektrischen Hochspannungsnetzes messen. Vorteilhaft weist einer der beiden Sensorköpfe mehr Windungen der Sensorspule auf und dient einer genauen Strommessung, beispielsweise für die Strom-Abrechnung, während der andere Sensorkopf mit weniger Windungen einen grösseren Messbereich hat und zum Netzschutz eingesetzt wird, wobei durch ihn Überströme im Kurzschlussfall eindeutig messbar sind.

Im folgenden werden noch zwei Methoden beschrieben, wie mit nur einem Phasenmodulator PM und nur einer Modulationsfrequenz $\nu$ im Zeit-Multiplexing-Verfahren ein gutes Signal-Rausch-Verhältnis erzielt werden kann, indem die Amplitude $\alpha_{0,n}$ der differentiellen Phase für jeden der N Sensorköpfe optimal eingestellt werden kann (vergleiche Aufbauten der Figs. 1 und 3):

Dies kann durch eine geeignete Wahl der Unterschiede zwischen den verschiedenen optischen Gesamtumlauflängen $\Lambda_n$ von der Lichtquelle durch den n-ten Sensorkopf zum Detektor erzielt werden. Die Amplitude $\alpha_{0,n}$ beispielsweise des nächstliegenden Sensorkopfes (kleinstes $\Lambda_n$) wird durch entsprechende Wahl der Gesamtumlauflänge $\Lambda_n$ optimal gewählt. Bei Detektion auf der ersten und der zweiten Harmonischen heisst das, dass dieses $\alpha_{0,n} = 1.84$ ist. Aufgrund der bereits genannten Gleichung

$$\alpha_{0,n} = 2 \cdot \Phi_{0,n} \cdot \sin(2\pi\nu T_n/2)$$

kann nun das Streckeninkrement zur nächst längeren optischen Gesamtumlauflänge $\Lambda_n$ so gewählt werden, dass sich das Argument des Sinus-Terms um $\pi$ ändert:

$$2\pi\nu_n\Delta T/2 = 2\pi\nu\Delta\Lambda/c = \pi \, ,$$

und somit

$$\Delta\Lambda = c/2\nu \, ,$$

wobei $\Delta\Lambda$ das Streckeninkrement ist, um das die minimale optische Gesamtumlauflänge $\Lambda_n$ verlängert werden muss, um die Änderung um $\pi$ zu erreichen, und $\Delta T$ ist die dementsprechende minimale Verlängerung der Umlaufzeit des Lichtes. Werden die weiteren optischen Gesamtumlauflängen $\Lambda_n$ um ein Vielfaches von $\Delta\Lambda$ gegenüber dem kleinsten $\Lambda_n$ erhöht, ist die Detektion für alle Sensorköpfe mit einem optimalen Signal-Rausch-Verhältnis möglich. Für eine Modulationsfrequenz von 130 kHz beträgt $\Delta\Lambda$ = 796 m. Je höher die Modulationsfrequenz $\nu$ gewählt ist, desto kleiner ist die benötigte Faserlänge.

Die zweite Möglichkeit, mit nur einem Phasenmodulator PM und nur einer Modulationsfrequenz $\nu$ im Zeit-Multiplexing-Verfahren für alle Sensorköpfe $H_n$ die Amplitude $\alpha_{0,n}$ auf ihren optimalen Wert (beispielsweise 1.84) einzustellen, besteht darin, mittels geeigneter Wahl der Treiberspannung des Phasenmodulators PM die Amplitude der Phasenmodulation $\phi_{0,n}$ in entsprechenden Zeitfenstern geeignet zu wählen. Wenn also (vergleiche Fig. 2) ab der Zeit $\Delta\tau_1$ nach Beginn eines Lichtpulses von der Lichtquelle 1 ein von dem ersten Sensorkopf $H_1$ stammendes Signal detektiert wird, ist die Amplitude $\phi_{0,1}$ der Phasenmodulation derart gewählt, dass $\alpha_{0,1}$ optimal ist. Wenn ab der Zeit $\Delta\tau_2$ nach Beginn eines Lichtpulses von der Lichtquelle 1 ein von dem zweiten Sensorkopf $H_2$ stammendes Signal detektiert wird, ist die Amplitude $\phi_{0,2}$ der Phasenmodulation derart zu wählen, dass $\alpha_{0,2}$ optimal ist, wobei $\alpha_{0,1}$ und $\alpha_{0,2}$ und die entsprechenden Treiberspannungen und $\phi_{0,1}$ und $\phi_{0,2}$ im allgemeinen verschieden gross sind. Es ist zu beachten, dass bei niedrigen Modulationsfrequenzen $\nu$ die zur Änderung der Amplituden $\phi_{0,n}$ der Phasenmodulation erforderliche Zeit wesentlich länger sein kann als die Wiederholfrequenz der Lichtpulse $1/\Delta t$. Während dieser Totzeit, in welcher die Amplitude geändert wird, ist die Signalgewinnung unterbrochen, so dass ein verschlechtertes Signal-Rausch-Verhältnis die Folge ist.

Bezugszeichenliste

| | |
|---|---|
| 1 | Lichtquelle |
| 2, $2_n$ | Detektor, Photodiode |
| 3, $3_n$ | detektorseitiges Ende der Phasenmodulationseinheit; Faserkoppler |
| 4, $4_n$ | sensorkopfseitiges Ende der Phasenmodulationseinheit; Faserkoppler |
| 5 | Steuerungs- und Auswerte-Einheit: Signalprozessor |
| 6 | erstes Mittel (zur Führung von Licht der Lichtquelle in ein detektorseitiges Ende der Phasenmodirlationseinheit) |
| 7 | zweites Mittel (zur Führung von Licht von dem detektorseitigen Ende der Phasenmodulationseinheit zum Detektor) |
| 8, $8_n$ | Polarisator, Faserpolarisator |
| 8', $8_n$' | Polarisator, Faserpolarisator |
| 9, $9_n$ | Mittel zur Änderung der Polarisationsrichtung, 90°-Spleiss |
| 9', $9_n$' | Mittel zur Änderung der Polarisationsrichtung, 45°-Spleiss |
| $10_n$ | faseroptische Zuleitung |
| $11_n$, $11_n$' | Phasenverzögerungselement, $\lambda$/4-Element |
| $12_n$ | Sensorspule, magnetooptisch aktive Faser |
| $13_n$ | Spiegel, verspiegeltes Ende |
| 14 | Faserkoppler |
| 15 | Faserkoppler |
| 16 | Faserkoppler |
| 17 | Faserkoppler |
| $18_n$ | Faserkoppier |
| | |
| $C_n$ | Stromleiter |
| D, $D_n$ | Detektorsignalleitung |
| $H_n$ | Sensorkopf |
| $I_{el,n}$ | zu messender erlektrischer Strom |
| $\ell_n$ | modulationsrelevante optische Weglänge |
| L | Lichtsteuerungssignalleitung |
| M, $M_n$ | Modulatorsignalleitung |
| N | ganze Zahl mit $N \geq 2$; Anzahl Sensorköpfe |
| $\Delta n_{gr}$ | Differenz der Gruppenbrechungsindizes für die zwei zueinander orthogonalen Lichtmoden |
| p | positive ganze Zahl |
| PM, $PM_n$ | Phasenmodulator, piezoelektrischer Modulator, integriert optischer Modulator |
| PME, $PME_n$ | Phasenmodulationseinheit, Modulatorkreis |
| q | positive ganze Zahl |
| $S_n$ | Ausgangs-Signal |
| $T_n$ | modulationsrelevante Umlaufzeit |
| At | Lichtpulsabstand |
| V | Verdet-Konstante (einer Sensorspule) |
| | |
| $\alpha_{0,n}$ | Amplitude der Modulation der differentiellen Phase |
| $\delta$ | Abstand (des Phasenmodulators vom Koppler in der SagnacKonfiguration) |
| $\Delta\phi_n$ | differentielle Phasenverschiebung aufgrund des Faraday-Effektes |
| $\Lambda_n$ | optische Gesamtumlauflänge (von der Lichtquelle 1 durch den n-ten Sensorkopf zum n-ten Detektor) |
| $\nu_n$ | Modulationsfrequenz |
| $\phi_{0,n}$ | Amplitude der Phasenmodulation |
| $\tau$ | Pulsdauer (eines Lichtpulses beim Zeit-Multiplexing) |
| $\Delta\tau_n$ | Laufzeit eines Lichtpulses von der Lichtquelle zum Detektor |

**Patentansprüche**

**1.** Faseroptischer Sensor zur Messung mindestens eines elektrischen Stromes oder Magnetfeldes, aufweisend

eine Lichtquelle (1),

N Sensorköpfe ($H_1,H_2,H_3$), die spulenförmig um Stromleiter ($C_1,C_2,C_3$) oder entlang des Magnetfeldes anordnbar sind, wobei N eine ganze Zahl mit $N \geq 2$ ist,

mindestens eine Phasenmodulationseinheit (PME; $PME_1$, $PME_2$, $PME_3$) mit mindestens einem Phasenmodulator (PM; $PM_1,PM_2,PM_3$),

mindestens einen Detektor ($2;2_1,2_2,2_3$), und

eine Steuerungs- und Auswerte-Einheit (5), die über mindestens eine Detektorsignalleitung (D; $D_1$, $D_2$, $D_3$) mit dem mindestens einen Detektor ($2;2_1,2_2,2_3$) und über mindestens eine Modulatorsignalleitung (M;$M_1,M_2,M_3$) mit dem mindestens einen Phasenmodulator (PM; $PM_1,PM_2,PM_3$) verbunden ist,

wobei erste Mittel (6) zur Führung von Licht der Lichtquelle (1) in ein detektorseitiges Ende ($3;3_1,3_2,3_3$) der Phasenmodulationseinheit (PME; $PME_1,PME_2,PME_3$) vorhanden sind,

wobei zweite Mittel (7) zur Führung von Licht von dem detektorseitigen Ende ($3;3_1,3_2,3_3$) der Phasenmodulationseinheit (PME;$PME_1,PME_2,PME_3$) zu dem Detektor ($2;2_1,2_2,2_3$) vorhanden sind,

wobei die mindestens eine Phaserimodulationseinheit (PME; $PME_1,PME_2,PME_3$) ein weiteres, sensorkopfseitiges Ende ($4;4_1,4_2,4_3$) aufweist, welches mit mindestens einem der Sensorköpfe ($H_1,H_2,H_3$) optisch verbunden ist, und

wobei mittels der mindestens einen Phasenmodulationseinheit (PME; $PME_1,PME_2,PME_3$) linear polarisierte Lichtwellen nicht-reziprok differentiell phasenmodulierbar sind,

**dadurch gekennzeichnet, dass**

für die nicht-reziproken differentiellen Phasenmodulationen N Modulationsamplituden $\phi_{0,n}$ und N Modulationsfrequenzen $\nu_n$ vorgesehen sind, wobei die Modulationsfrequenzen $\nu_n$ und zwei vorgebbare positive ganze Zahlen p, q mit $p \neq q$ derart gewählt sind, dass für alle positiven ganzen Zahlen z und für alle ganzen Zahlen n, m mit $n \neq m$ und $1 \leq n,m \leq N$ gilt:

$$p \cdot \nu_n \quad \neq \quad z \cdot \nu_m$$

und

$$q \cdot \nu_n \quad \neq \quad z \cdot \nu_m \, ,$$

und wobei die Modulationsamplituden $\phi_{0,n}$ und die Modulationsfrequenzen $\nu_n$ in Abhängigkeit von modulationsrelevanten optischen Weglängen $\ell_n$ gewählt sind.

2. Sensor gemäss Anspruch 1, **dadurch gekennzeichnet, dass** genau eine Steuerungs- und Auswerte-Einheit (5) aufgewiesen wird, in welcher Signale, die von den verschiedenen Sensorköpfen ($H_1,H_2,H_3$) stammen und über die mindestens eine Detektorsignalleitung (D;$D_1,D_2,D_3$) der Steuerungs- und Auswerte-Einheit (5) zugeführt sind, mittels Frequenzfilterung voneinander unterscheidbar sind, wobei diese Signale in N Ausgangs-Signale $S_n$ umwandelbar sind, insbesondere wobei in der Steuerungs- und Auswerte-Einheit (5) die Ausgangs-Signale $S_n$ für jedes n mit $1 \leq n \leq N$ aus Signalen bei den Frequenzen $p \cdot \nu_n$ und $q \cdot \nu_n$ bestimmbar sind.

3. Sensor gemäss einem der Ansprüche 1 oder 2, **dadurch gekennzeichnet, dass** genau eine Phasenmodulationseinheit (PME) aufgewiesen wird, und dass N Reflexionsinterferometer aufgewiesen werden, wobei jedes der N Reflexionsinterferometer genau einen der N Sensorköpfe ($H_1,H_2,H_3$) beinhaltet, und wobei die N Sensorköpfe ($H_1,H_2,H_3$) jeweils ein verspiegeltes Ende ($13_1,13_2,13_3$) aufweisen.

4. Sensor gemäss Anspruch 3, **dadurch gekennzeichnet, dass** die Lichtquelle (1) über eine Lichtsteuerungssignalleitung (L) mit der Steuerungs- und Auswerte-Einheit (5) verbunden ist, und dass zur Messung ein Zeit-Multiplexing-Verfahren vorgesehen ist.

5. Sensor gemäss einem der Ansprüche 3 oder 4, **dadurch gekennzeichnet, dass** die Phasenmodulationseinheit (PME) entweder

(a) ein Modulatorkreis (PME) mit N Phasenmodulatoren ($PM_1,PM_2,PM_3$), insbesondere piezoelektrischen Phasenmodulatoren (PM; $PM_1,PM_2,PM_3$), ist, wobei jedem der N Phasenmodulatoren ($PM_1$, $PM_2$, $PM_3$) genau eine der N Modulationsfrequenzen $\nu_n$ zugeordnet ist, und dass jeder der N Phasenmodulatoren ($PM_1$, $PM_2$, $PM_3$)

mit der ihm zugeordneten Modulationsfrequenz $\nu_n$ betreibbar ist, und dass die differentielle Phase von gegenläufigen, zueinander parallel polarisierten Lichtwellen modulierbar ist, oder

(b) einen einzigen Phasenmodulator (PM), insbesondere einen integriert-optischen Phasenmodulator (PM), beinhaltet, welcher eine simultane Phasenmodulation mit den N verschiedenen Modulationsfrequenzen $\nu_n$ erlaubt, und wobei die differentielle Phase von sich in dieselbe Richtung ausbreitenden, zueinander orthogonal polarisierten Lichtwellen modulierbar ist.

6. Sensor gemäss einem der Ansprüche 1 oder 2, **dadurch gekennzeichnet, dass** N Phasenmodulationseinheiten ($PME_1, PME_2, PME_3$) mit je einem Phasenmodulator ($PM_1, PM_2, PM_3$) aufgewiesen werden, wobei die n-te Phasenmodulationseinheit ($PME_n$) mit dem n-ten Sensorkopf ($H_n$) optisch verbunden ist und der n-te Phasenmodulator ($PM_n$) mit der Modulationsfrequenz $\nu_n$ betreibbar ist und jeder der Phasenmodulatoren ($PM_1, PM_2, PM_3$) über je eine Modulatorsignalleitung ($M_1, M_2, M_3$) mit der Steuerungs- und Auswerte-Einheit (5) verbunden ist.

7. Sensor gemäss Anspruch 6, **dadurch gekennzeichnet,**
**dass** N Reflexionsinterferometer aufgewiesen werden, wobei jedes der N Reflexionsinterferometer genau einen der N Sensorköpfe ($H_1, H_2, H_3$) beinhaltet, und wobei die N Sensorköpfe ($H_1, H_2, H_3$) jeweils ein verspiegeltes Ende ($13_1, 13_2, 13_3$) aufweisen und, dass entweder

(a) die Phasenmodulationseinheiten ($PME_1, PME_2, PME_3$) Modulatorkreise ($PME_1, PME_2, PME_3$) sind, und dass durch die Phasenmodulatoren ($PM_1, PM_2, PM_3$) die differentielle Phase von gegenläufigen, zueinander parallel polarisierten Lichtwellen modulierbar ist, und insbesondere dass die Phasenmodulatoren ($PM_1, PM_2, PM_3$) piezoelektrische Phasenmodulatoren ($PM_1, PM_2, PM_3$) sind, oder

(b) durch jeden der Phasenmodulatoren ($PM_1, PM_2, PM_3$) die differentielle Phase von sich in dieselbe Richtung ausbreitenden, zueinander orthogonal polarisierten Lichtwellen modulierbar ist, und insbesondere dass die Phasenmodulatoren ($PM_1, PM_2, PM_3$) integriert-optische Phasenmodulatoren ($PM_1, PM_2, PM_3$) sind.

8. Sensor gemäss Anspruch 6, **dadurch gekennzeichnet,**
**dass** N Sagnac-Interferometer aufgewiesen werden, wobei jedes der N Sagnac-Interferometer genau einen der N Sensorköpfe ($H_1, H_2, H_3$) beinhaltet, und
**dass** jede der Phasenmodulationseinheiten ($PME_1, PME_2, PME_3$) im wesentlichen je ein Phasenmodulator ($PM_1, PM_2, PM_3$) ist, wobei mittels der Phasenmodulatoren ($PM_1, PM_2, PM_3$) die differentielle Phase von gegenläufigen, zueinander parallel polarisierten Lichtwellen modulierbar ist, und insbesondere dass die Phasenmodulatoren ($PM_1, PM_2, PM_3$) piezoelektrische Phasenmodulatoren ($PM_1, PM_2, PM_3$) oder integriert-optische Modulatoren ($PM_1, PM_2, PM_3$) sind.

9. Sensor gemäss einem der vorangegangenen Ansprüche, **dadurch gekennzeichnet, dass** p = 1 und q = 2 gewählt ist, und dass die N Modulationsamplituden $\phi_{0,n}$ und die N Modulationsfrequenzen $\nu_n$ derart gewählt sind, dass Amplituden $\alpha_{0,n}$ der Modulation der differentiellen Phase der linear polarisierten Lichtwellen für alle n mit $1 \leq n \leq N$ zwischen 1.7 und 2.0, insbesondere zwischen 1.8 und 1.88, liegen oder im wesentlichen 1.84 betragen.

10. Sensor gemäss einem der vorangegangenen Ansprüche, **dadurch gekennzeichnet, dass** entweder

(a) genau ein Detektor (2) aufgewiesen wird, oder
(b) N Detektoren ($2_1, 2_2, 2_3$) aufgewiesen werden, wobei jeder der Detektoren ($2_1, 2_2, 2_3$) über je einer Detektorsignalleitung ($D; D_1, D_2, D_3$) mit der Steuerungs- und Auswerte-Einheit (5) verbunden ist.

11. Sensor gemäss einem der vorangegangenen Ansprüche, **dadurch gekennzeichnet, dass** N = 3 oder N = 6 ist, wobei die elektrischen Ströme dreier Phasen eines elektrischen Hochspannungsnetzes im Fall N = 3 mittels je eines Sensorkopfes ($H_1; H_2; H_3$) oder im Fall N = 6 mittels je zweier Sensorköpfe ($H_n$) messbar sind.

12. Verfahren zur Messung mindestens eines elektrischen Stromes oder mindestens eines Magnetfeldes, wobei von einer Lichtquelle (1) Lichtwellen emittiert werden, die in linear polarisierte lichtwellen umgewandelt werden, und wobei die linear polarisierten Lichtwellen in N Sensorköpfe ($H_1, H_2, H_3$) geführt werden, in welchen die Lichtwellen eine von dem zu messenden Strom oder Magnetfeld abhängige Phasenverschiebung erfahren, wobei N eine ganze Zahl mit $N \geq 2$ ist, und
wobei die Lichtwellen in mindestens einem Detektor ($2; 2_1, 2_2, 2_3$) detektiert werden, und
wobei die Lichtwellen in mindestens einer Phasenmodulationseinheit (PME; $PME_1, PME_2, PME_3$) mit mindestens einem Phasenmodulator (PM; $PM_1, PM_2, PM_3$) eine nicht-reziproke differentielle Phasenmodulation erfahren, wobei die mindestens eine Phasenmodulationseinheit (PME; PMEi,PME$_2$,PME$_3$) von den Lichtwellen sowohl bei deren Ausbreitung von der Lichtquelle (1) zu den Sensorköpfen (H$_1$, H$_2$, H$_3$) als auch bei deren Ausbreitung von den Sensorköpfen (H$_1$,H$_2$,H$_3$) zu dem mindestens einen Detektor (2;2$_1$,2$_2$,2$_3$) durchlaufen wird, und

wobei mittels einer Steuerungs- und Auswerte-Einheit (5) sowohl der mindestens eine Phasenmodulator (PM; PM$_1$, PM$_2$, PM$_3$) gesteuert wird als auch von dem mindestens einen Detektor (2; 2$_1$, 2$_2$, 2$_3$) stammende Signale ausgewertet werden,

**dadurch gekennzeichnet, dass**

die Lichtwellen mit N Modulationsamplituden $\Phi_{0,n}$ und N Modulationsfrequenzen $\nu_n$ nicht-reziprok differentiell phasenmoduliert werden, wobei die Modulationsfrequenzen $\nu_n$ und zwei vorgebbare positive ganze Zahlen p, q mit p $\neq$ q derart gewählt werden, dass für alle positiven ganzen Zahlen z und für alle ganzen Zahlen n, m mit n $\neq$ m und $1 \leq$ n,m $\leq$ N gilt:

$$p \cdot \nu_n \quad \neq \quad z \cdot \nu_m$$

und

$$q \cdot \nu_n \quad \neq \quad z \cdot \nu_m \, ,$$

und wobei die Modulationsamplituden $\phi_{0,n}$ und die Modulationsfrequenzen $\nu_n$ in Abhängigkeit von modülationsielevanten optischen Weglängen $\ell_n$ gewählt werden.

## Claims

1. Fiberoptic sensor for measuring at least one electric current or magnetic field, having
   a light source (1),
   N sensor heads (H$_1$, H$_2$, H$_3$) that can be arranged in the shape of a coil around current conductors (C$_1$, C$_2$, C$_3$) or along the magnetic field, N being a whole number with N $\geq$ 2,
   at least one phase modulation unit (PME; PME$_1$,PME$_2$,PME$_3$), having at least one phase modulator (PM; PM$_1$, PM$_2$, PM$_3$),
   at least one detector (2;2$_1$,2$_2$,2$_3$), and
   a control and evaluation unit (5) that is connected via at least one detector signal line (D; D$_1$, D$_2$, D$_3$) to the at least one detector (2; 2$_1$, 2$_2$, 2$_3$), and via at least one modulator signal line (M; M$_1$, M$_2$, M$_3$) to the at least one phase modulator (PM; PM$_1$, PM$_2$, PM$_3$),
   first means (6) being available for guiding light of the light source (1) into an end (3; 3$_1$, 3$_2$, 3$_3$), on the detector side, of the phase modulation unit (PME; PME$_1$, PME$_2$, PME$_3$),
   second means (7) being available for guiding light from the end (3;3$_1$,3$_2$,3$_3$), on the detector side, of the phase modulation unit (PME; PME$_1$, PME$_2$, PME$_3$) to the detector (2; 2$_1$, 2$_2$, 2$_3$),
   the at least one phase modulation unit (PME; PME$_1$,PME$_2$,PME$_3$) having a further end (4; 4$_1$, 4$_2$, 4$_3$), on the sensor head side, that is optically connected to at least one of the sensor heads (H$_1$,H$_2$,H$_3$), and
   it being possible for linearly polarized lightwaves to be phase-modulated differentially in a non-reciprocal fashion by means of the at least one phase modulation unit (PME; PME$_1$, PME$_2$, PME$_3$), **characterized in that** N modulation amplitudes $\phi_{0,n}$ and N modulation frequencies $\nu_n$ are provided for the non-reciprocal differential phase modulations, the modulation frequencies $\nu_n$ and two prescribable positive whole numbers p, q with p $\neq$ q being selected in such a way that it holds for all positive whole numbers z and for all whole numbers n, m with n $\neq$ m and $1 \leq$ n,m $\leq$ N that:

$$p \bullet \nu_n \quad \neq \quad z \bullet \nu_m$$

and

$$q \bullet \nu_n \quad \neq \quad z \bullet \nu_m,$$

and the modulation amplitudes $\phi_{0,n}$ and the modulation frequencies $v_n$ being selected as a function of modulation-relevant optical path lengths $\ell_n$.

2. Sensor according to Claim 1, **characterized in that** exactly one control and evaluation unit (5) is provided, in which signals that originate from the various sensor heads ($H_1$, $H_2$, $H_3$) and are fed to the control and evaluation unit (5) via the at least one detector signal line (D; $D_1$, $D_2$, $D_3$) can be distinguished from one another by means of frequency filtering, it being possible to convert these signals into N output signals $S_n$, in particular it being possible to determine the output signals $S_n$ for each n with $1 \leq n \leq N$ from signals at the frequencies $p \cdot v_n$ and $q \cdot v_n$ in the control and evaluation unit (5).

3. Sensor according to one of Claims 1 or 2, **characterized in that** exactly one phase modulation unit (PME) is provided, and **in that** N reflection interferometers are provided, each of the N reflection interferometers including exactly one of the N sensor heads ($H_1$, $H_2$, $H_3$), and the N sensor heads ($H_1$, $H_2$, $H_3$) in each case having a silvered end ($13_1$, $13_2$, $13_3$).

4. Sensor according to Claim 3, **characterized in that** the light source (1) is connected to the control and evaluation unit (5) via a light control signal line (L), and **in that** a time division multiplexing method is provided for the measurement.

5. Sensor according to one of Claims 3 or 4, **characterized in that** the phase modulation unit (PME) either

    (a) is a modulator circuit (PME) having N phase modulators ($PM_1$,$PM_2$,$PM_3$), in particular piezoelectric phase modulators (PM; $PM_1$,$PM_2$,$PM_3$), each of the N phase modulators ($PM_1$, $PM_2$, $PM_3$) being assigned exactly one of the N modulation frequencies $v_n$, and **in that** each of the N phase modulators ($PM_1$,$PM_2$,$PM_3$) can be operated with the aid of the modulation frequency $v_n$ assigned to it, and **in that** the differential phase of oppositely directed lightwaves polarized parallel to one another can be modulated, or
    (b) includes a single phase modulator (PM), in particular an integrated optical phase modulator (PM), which permits a simultaneous phase modulation with the N various modulation frequencies $v_n$, and it being possible to modulate the differential phase of lightwaves that propagate in the same direction and are mutually orthogonally polarized.

6. Sensor according to one of Claims 1 or 2, **characterized in that** N phase modulation units ($PME_1$,$PME_2$,$PME_3$) having one phase modulator ($PM_1$,$PM_2$,$PM_3$) each are provided, the nth phase modulation unit ($PME_n$) being optically connected to the nth sensor head ($H_n$), and it being possible to operate the nth phase modulator ($PM_n$) with the modulation frequency $v_n$, and each of the phase modulators ($PM_1$, $PM_2$, $PM_3$) being connected to the control and evaluation unit (5) via one modulator signal line ($M_1$,$M_2$,$M_3$) each.

7. Sensor according to Claim 6, **characterized in that** N reflection interferometers are provided, each of the N reflection interferometers including exactly one of the N sensor heads ($H_1$, $H_2$, $H_3$), and the N sensor heads ($H_1$,$H_2$,$H_3$) in each case having a silvered end ($13_1$,$13_2$,$13_3$), and **in that** either

    (a) the phase modulation units ($PME_1$, $PME_2$, $PME_3$) are modulator circuits ($PME_1$, $PME_2$, $PME_3$), and **in that** it is possible to modulate the differential phase of oppositely directed lightwaves polarized parallel to one another by means of the phase modulators ($PM_1$, $PM_2$, $PM_3$), and in particular **in that** the phase modulators ($PM_1$, $PM_2$, $PM_3$) are piezoelectric phase modulators ($PM_1$, $PM_2$, $PM_3$), or
    (b) each of the phase modulators ($PM_1$, $PM_2$, $PM_3$) can modulate the differential phase of mutually orthogonally polarized lightwaves propagating in the same direction and, in particular, **in that** the phase modulators ($PM_1$, $PM_2$,$PM_3$) are integrated optical phase modulators ($PM_1$, $PM_2$, $PM_3$).

8. Sensor according to Claim 6, **characterized in that** N Sagnac interferometers are provided, each of the N Sagnac interferometers including exactly one of the N sensor heads ($H_1$,$H_2$,$H_3$), and
    **in that** each of the phase modulation units ($PME_1$, $PME_2$, $PME_3$) is essentially one phase modulator ($PM_1$, $PM_2$, $PM_3$) in each case, it being possible to modulate the differential phase of oppositely directed lightwaves, polarized parallel to one another, by means of the phase modulators ($PM_1$,$PM_2$,$PM_3$), and
    particularly in that the phase modulators ($PM_1$,$PM_2$,$PM_3$) are piezoelectric phase modulators ($PM_1$,$PM_2$,$PM_3$) or integrated optical modulators ($PM_1$,$PM_2$,$PM_3$).

**9.** Sensor according to one of the preceding claims, **characterized in that** selection p = 1 and q = 2 is made, and **in that** the N modulation amplitudes $\phi_{0,n}$ and the N modulation frequencies $\nu_n$ are selected in such a way that amplitudes $\alpha_{0,n}$ of the modulation of the differential phase of the linearly polarized lightwaves lie between 1.7 and 2.0, in particular between 1.8 and 1.88, or are essentially 1.84 for all n with $1 \leq n \leq N$.

**10.** Sensor according to one of the preceding claims, **characterized in that** either

(a) exactly one detector (2) is provided, or
(b) N detectors ($2_1, 2_2, 2_3$) are provided, each of the detectors ($2_1, 2_2, 2_3$) being connected to the control and evaluation unit (5) via one detector signal line ($D; D_1, D_2, D_3$) in each case.

**11.** Sensor according to one of the preceding claims, **characterized in that** N = 3 or N = 6, the electric currents of three phases of an electric high voltage system being able to be measured by means of one sensor head ($H_1; H_2; H_3$) each in the case of N = 3, or being able to be measured by means of two sensor heads ($H_n$) each in the case of N = 6.

**12.** Method for measuring at least one electric current or at least one magnetic field, a light source (1) emitting lightwaves that are converted into linearly polarized lightwaves, and
the linearly polarized lightwaves being guided into N sensor heads ($H_1$, $H_2$, $H_3$) in which the lightwaves undergo a phase shift dependent on the current or magnetic field to be measured, N being a whole number with $N \geq 2$, and
the lightwaves being detected in at least one detector (2; $2_1$, $2_2$, $2_3$), and
the lightwaves undergoing a non-reciprocal differential phase modulation in at least one phase modulation unit (PME; $PME_1$, $PME_2$, $PME_3$) having at least one phase modulator (PM; $PM_1$, $PM_2$, $PM_3$), the at least one phase modulation unit (PME; $PME_1$, $PME_2$, $PME_3$) being traversed by the lightwaves both during their propagation from the light source (1) to the sensor heads ($H_1, H_2, H_3$) and during their propagation from the sensor heads ($H_1, H_2, H_3$) to the at least one detector (2; $2_1, 2_2, 2_3$), and a control and evaluation unit (5) being used both to control the at least one phase modulator (PM; $PM_1$, $PM_2$, $PM_3$) and to evaluate signals originating from the at least one detector (2; $2_1$, $2_2, 2_3$),
**characterized in that**
the lightwaves are differentially phase-modulated in a non-reciprocal fashion with N modulation amplitudes $\phi_{0,n}$ and N modulation frequencies $\nu_n$, the modulation frequencies $\nu_n$ and two prescribable positive whole numbers p, q with $p \neq q$ being selected in such a way that it holds for all positive whole numbers z and for all whole numbers n, m with $n \neq m$ and $1 \leq n, m \leq N$ that:

$$p \bullet \nu_n \neq z \bullet \nu_m$$

and

$$q \bullet \nu_n \neq z \bullet \nu_m,$$

and the modulation amplitudes $\phi_{0,n}$ and the modulation frequencies $\nu_n$ being selected as a function of modulation-relevant optical path lengths $\ell_n$.

**Revendications**

**1.** Capteur à fibres optiques pour mesurer au moins un courant électrique ou un champ magnétique, possédant une source lumineuse (1),
N têtes de détection ($H_1$, $H_2$, $H_3$) qui peuvent être disposées en forme de bobine autour du conducteur de courant ($C_1$, $C_2$, $C_3$) ou le long du champ magnétique, N étant un nombre entier $\geq 2$,
au moins une unité de modulation de phase (PME; $PME_1$, $PME_2$, $PME_3$) avec au moins un modulateur de phase (PM; $PM_1$, $PM_2$, $PM_3$),
au moins un détecteur (2; $2_1$, $2_2$, $2_3$),
et une unité de commande et d'analyse (5) qui est reliée par au moins une ligne de signaux de détecteur (D; $D_1$, $D_2$, $D_3$) avec l'au moins un détecteur (2; $2_1$, $2_2$, $2_3$) et par au moins une ligne de signaux de modulateur (M; $M_1$, $M_2$, $M_3$) avec l'au moins un modulateur de phase (PM; $PM_1$, $PM_2$, $PM_3$),

dans lequel il existe des premiers moyens (6) pour guider la lumière de la source lumineuse (1) à une extrémité côté détecteur (3; $3_1$, $3_2$, $3_3$) de l'unité de modulation de phase (PME; $PME_1$, $PME_2$, $PME_3$),

dans lequel il existe des deuxièmes moyens (7) pour guider la lumière de l'extrémité côté détecteur (3; $3_1$, $3_2$, $3_3$) de l'unité de modulation de phase (PME; $PME_1$, $PME_2$, $PME_3$) au détecteur (2; $2_1$, $2_2$, $2_3$),

dans lequel l'au moins une unité de modulation de phase (PME; $PME_1$, $PME_2$, $PME_3$) comprend une autre extrémité du côté têtes de détection (4; $4_1$, $4_2$, $4_3$) qui est reliée optiquement avec au moins une des têtes de détection ($H_1$, $H_2$, $H_3$), et

dans lequel des sources lumineuses à polarisation linéaire peuvent être soumises à une modulation de phase différentielle non réciproque par le biais de l'au moins une unité de modulation de phase (PME; $PME_1$, $PME_2$, $PME_3$),

**caractérisé en ce que**

pour les modulations de phase différentielles non réciproques sont prévues N amplitudes de modulation $\phi_{0,n}$ et N fréquences de modulation $\nu_n$, les fréquences de modulation $\nu_n$ et deux nombres entiers positifs pouvant être prédéfinis p, q tels que $p \neq q$ étant choisis de telle sorte que, pour tous les nombres entiers positifs z et pour tous les nombres entiers n, m tels que $n \neq m$ et $1 \leq n$, $m \leq N$, on a :

$$p \star \nu_n \neq z \star \nu_m$$

et

$$q \star \nu_n \neq z \star \nu_m,$$

et les amplitudes de modulation $\phi_{0,n}$ et les fréquences de modulation $\nu_n$ étant choisies en fonction de longueurs de chemin optique $\ell_n$ correspondant à la modulation.

2. Capteur selon la revendication 1, **caractérisé en ce qu'**est présente exactement une unité de commande et d'analyse (5) dans laquelle des signaux qui proviennent des différentes têtes de détection ($H_1$, $H_2$, $H_3$) et sont transmis à l'unité de commande et d'analyse (5) par l'au moins une ligne de signaux de détecteur (D; $D_1$, $D_2$, $D_3$) peuvent être différentiés les uns des autres par filtrage fréquentiel, ces signaux pouvant être convertis en N signaux de sortie $S_n$, en particulier, les signaux de sortie $S_n$ pour tout n tel que $1 \leq n \leq N$ à partir de signaux aux fréquences $p \star \nu_n$ et $q \star \nu_n$ pouvant être déterminés dans l'unité de commande et d'analyse (5).

3. Capteur selon une des revendications 1 ou 2, **caractérisé en ce qu'**est présente exactement une unité de modulation de phase (PME) et que sont présents N interféromètres à réflexion, chacun des N interféromètres à réflexion contenant exactement une des N têtes de détection ($H_1$, $H_2$, $H_3$), et les N têtes de détection ($H_1$, $H_2$, $H_3$) possédant chacune une extrémité réfléchissante ($13_1$, $13_2$, $13_3$).

4. Capteur selon la revendication 3, **caractérisé en ce que** la source lumineuse (1) est reliée avec l'unité de commande et d'analyse (5) par une ligne de signaux de commande de lumière (L) et qu'un procédé de multiplexage temporel est prévu pour la mesure.

5. Capteur selon une des revendications 3 ou 4, **caractérisé en ce que** l'unité de modulation de phase (PME) soit

(a) est un circuit de modulation (PME) avec N modulateurs de phase ($PM_1$, $PM_2$, $PM_3$), en particulier des modulateurs de phase piézoélectriques (PM, $PM_1$, $PM_2$, $PM_3$) à chacun des N modulateurs de phase ($PM_1$, $PM_2$, $PM_3$) étant affectée exactement une des N fréquences de modulation $\nu_n$, chacun des N modulateurs de phase ($PM_1$, $PM_2$, $PM_3$) pouvant fonctionner avec la fréquences de modulation $\nu_n$ qui lui est affectée, et la phase différentielle d'ondes lumineuses polarisées parallèlement entre elles se propageant dans des directions opposées pouvant être modulée, soit

(b) contient un unique modulateur de phase (PM), en particulier un modulateur de phase à optique intégrée (PM) qui permet une modulation de phase simultanée avec les N fréquences de modulation $\nu_n$ différentes, la phase différentielle d'ondes lumineuses polarisées de manière orthogonale entre elles se propageant dans la même direction pouvant être modulée.

6. Capteur selon une des revendications 1 ou 2, **caractérisé en ce que** sont présentes N unités de modulation de phase ($PME_1$, $PME_2$, $PME_3$) avec chacune un modulateur de phase ($PM_1$, $PM_2$, $PM_3$), la n-ième unité dé modulation

de phase (PME$_n$) étant reliée optiquement avec la n-ième tête de détection (H$_n$), le n-ième modulateur de phase (PM$_n$) fonctionnant avec la fréquence de modulation $\nu_n$ et chacun des modulateurs de phase (PM$_1$, PM$_2$, PM$_3$) étant relié par une ligne de signaux de modulateur (M$_1$, M$_2$, M$_3$) avec l'unité de commande et d'analyse (5).

**7.** Capteur selon la revendication 6, **caractérisé en ce que** sont présents N interféromètres à réflexion, chacun des N interféromètres à réflexion contenant exactement une des N têtes de détection (H$_1$, H$_2$, H$_3$), les N têtes de détection (H$_1$, H$_2$, H$_3$) possédant chacune une extrémité réfléchissante (13$_1$, 13$_2$, 13$_3$), et que soit

> (a) les unités de modulation de phase (PME$_1$, PME$_2$, PME$_3$) sont des circuits de modulation (PME$_1$, PME$_2$, PME$_3$), la phase différentielle d'ondes lumineuses polarisées parallèlement entre elles se propageant dans des directions opposées pouvant être modulée par les modulateurs de phase (PM$_1$, PM$_2$, PM$_3$), les modulateurs de phase (PM$_1$, PM$_2$, PM$_3$), étant en particulier des modulateurs de phase piézoélectriques (PM$_1$, PM$_2$, PM$_3$), soit
> (b) la phase différentielle d'ondes lumineuses polarisées de manière orthogonale entre elles se propageant dans la même direction peut être modulée par chacun des modulateurs de phase (PM$_1$, PM$_2$, PM$_3$), les modulateurs de phase (PM$_1$, PM$_2$, PM$_3$) étant en particulier des modulateurs de phase à optique intégrée (PM$_1$, PM$_2$, PM$_3$).

**8.** Capteur selon la revendication 6, **caractérisé en ce que** sont présents N interféromètres de Sagnac, chacun des N interféromètres de Sagnac contenant exactement une des N têtes de détection (H$_1$, H$_2$, H$_3$), et que chacune des unités de modulation de phase (PME$_1$, PME$_2$, PME$_3$) est pour l'essentiel un modulateur de phase (PM$_1$, PM$_2$, PM$_3$), la phase différentielle d'ondes lumineuses polarisées parallèlement entre elles se propageant dans des directions opposées pouvant être modulée par les modulateurs de phase (PM$_1$, PM$_2$, PM$_3$), les modulateurs de phase (PM$_1$, PM$_2$, PM$_3$) étant en particulier des modulateurs de phase piézoélectriques (PM$_1$, PM$_2$, PM$_3$) ou des modulateurs de phase à optique intégrée (PM$_1$, PM$_2$, PM$_3$).

**9.** Capteur selon une des revendications précédentes, **caractérisé en ce que** p = 1 et q = 2, et que les N amplitudes de modulation $\phi_{0,n}$ et les N fréquences de modulation $\nu_n$ sont choisies de telle sorte que les amplitudes $\alpha_{0,n}$ de la modulation de la phase différentielle des ondes lumineuses à polarisation linéaire sont situées, pour toutes les valeurs n telles que $1 \leq n \leq N$, entre 1,7 et 2,0, en particulier entre 1,8 et 1,88 ou sont sensiblement égales à 1,84.

**10.** Capteur selon une des revendications précédentes, **caractérisé en ce que** soit

> (a) est présent exactement un détecteur (2), soit
> (b) sont présents N détecteurs (2$_1$, 2$_2$, 2$_3$), chacun des détecteurs (2$_1$, 2$_2$, 2$_3$) étant reliés chacun par une ligne de signaux de détecteur (D; D$_1$, D$_2$, D$_3$) avec l'unité de commande et d'analyse (5).

**11.** Capteur selon une des revendications précédentes, **caractérisé en ce que** N = 3 ou N = 6, les courants électriques des trois phases d'un réseau électrique à haute tension pouvant être mesuré chacun à l'aide d'une tête de détection (H$_1$, H$_2$, H$_3$) dans le cas où N = 3 ou à l'aide de deux têtes de détection (H$_n$) dans le cas où N = 6.

**12.** Procédé pour mesurer au moins un courant électrique ou un champ magnétique, dans lequel par une source lumineuse (1) sont émises des ondes lumineuses qui sont converties en ondes lumineuses à polarisation linéaire, dans lequel les ondes lumineuses à polarisation linéaire sont guidées dans N têtes de détection (H$_1$, H$_2$, H$_3$) dans lesquelles les ondes lumineuses subissent un déphasage dépendant du courant ou du champ magnétique à mesurer, N étant un nombre entier $\geq 2$, et
dans lequel les ondes lumineuses sont détectées dans au moins un détecteur (2; 2$_1$, 2$_2$, 2$_3$), et
dans lequel les ondes lumineuses subissent une modulation de phase différentielle non réciproque dans au moins une unité de modulation de phase (PME; PME$_1$, PME$_2$, PME$_3$) avec au moins un modulateur de phase (PM; PM$_1$, PM$_2$, PM$_3$), l'au moins une unité de modulation de phase (PME; PME$_1$, PME$_2$, PME$_3$) étant parcourue par les ondes lumineuses aussi bien lors de leur propagation de la source lumineuse (1) aux têtes de détection (H$_1$, H$_2$, H$_3$) que lors de leur propagation des têtes de détection (H$_1$, H$_2$, H$_3$) à l'au moins un détecteur (2; 2$_1$, 2$_2$, 2$_3$), et
dans lequel une unité de commande et d'analyse (5) commande, d'une part, l'au moins un modulateur de phase (PM; PM$_1$, PM$_2$, PM$_3$), et analyse, d'autre part, des signaux provenant de l'au moins un détecteur (2; 2$_1$, 2$_2$, 2$_3$, **caractérisé en ce que** les ondes lumineuses sont modulées en phase de manière différentielle non réciproque avec N amplitudes de modulation $\phi_{0,n}$ et N fréquences de modulation $\nu_n$, les fréquences de modulation $\nu_n$ et deux nombres entiers positifs pouvant être prédéfinis p, q tels que $p \neq q$ étant choisis de telle sorte que, pour tous les nombres entiers positifs z et pour tous les nombres entiers n, m tels que $n \neq m$ et $1 \leq n,m \leq N$, on a :

$$p * \nu_n \neq z * \nu_m$$

et

$$q * \nu_n \neq z * \nu_m,$$

et les amplitudes de modulation $\phi_{0,n}$ et les fréquences de modulation $\nu_n$ étant choisies en fonction de longueurs de chemin optique $\ell_n$ correspondant à la modulation.

**Fig. 1**

EP 1 597 599 B1

Fig. 2

EP 1 597 599 B1

**Fig. 3**

Fig. 4

EP 1 597 599 B1

Fig. 5

Fig. 6

**Fig. 7**

EP 1 597 599 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1154278 A2

**In der Beschreibung aufgeführte Nicht-Patentliteratur**

- **G. FROSIO ; R. DÄNDLIKER.** Reciprocal Reflection Interferometer for a Fiber-Optic Faraday Current Sensor. *Appl. Opt.,* 1994, vol. 33, 61 11

- **J. BLAKE ; P. TANTASWADI ; R. T. DE CARVAL-HO.** In-line Sagnac Interferometer Current Sensor. *IEEE Transactions on Power Delivery,* 1996, vol. 11, 116-121